# EUROPÄISCHE PATENTANMELDUNG

(11) **EP 3 182 448 A1**
(43) Veröffentlichungstag der Anmeldung: **21.06.2017**
(21) Anmeldenummer: 16002447.7
(22) Anmeldetag: 17.11.2016
(51) Int. Cl.: H01L 23/40, H02K 5/20, H02K 11/33

(54) **MULTIFUNKTIONALE MODULVERBINDUNGSSTRUKTUR**

(30) Priorität: 18.12.2015 DE 102015122250
(71) Anmelder: Karlsruher Institut für Technologie, 76131 Karlsruhe (DE)
(72) Erfinder: Blank, Thomas, 76187 Karlsruhe (DE); Meißer, Michael, 76137 Karlsruhe (DE)

(57) **Zusammenfassung**

Eine Vorrichtung (100), aufweisend: mindestens eine erste und eine zweite thermisch und elektrisch aktive
Baugruppe (110, 120), wobei die zweite Baugruppe (120) derart über der ersten Baugruppe (110) angeordnet ist, dass thermische Energie (T) durch die beiden aneinander angrenzenden Oberflächen (112, 124) austauschbar ist; und mindestens eine multifunktionale
Verbindungsvorrichtung (130), aufweisend: mindestens drei Bauelemente (132, 134, 136) dadurch gekennzeichnet, dass das erste Bauelement (132) mindestens einen elektrisch isolierenden Körper aufweist; das zweite Bauelement (134) mindestens einen elektrisch leitfähigen Körper aufweist, wobei das erste Bauelement eine elektrische Isolierung zwischen dem zweiten Bauelement und mindestens einer der beiden Baugruppen (110, 120) herstellt; das dritte Bauelement (136) mindestens einen elektrisch leitfähigen und mechanisch federnden Körper aufweist; sich das zweite Bauelement (134) durch das erste Bauelement (132) hindurch erstreckt und fest oder drehbar mit dem ersten Bauteil (132) verbunden ist; sich das zweite Bauelement (134) zumindest teilweise über das erste Bauelement (132) hinaus erstreckt; das erste Bauelement (132) fest in mindestens eine der beiden Baugruppen (110, 120) eingesetzt ist; sich das erste und das zweite Bauelement (132, 134) zumindest teilweise durch eine der beiden Baugruppen (110, 120) hindurch erstrecken; das dritte Bauelement (136) eine elastische Verbindung zwischen der zweiten Baugruppe (120) und dem zweiten Bauelement (134) bildet; und zumindest die elastische Verbindung eine Vorspannung der beiden Baugruppen (110, 120) gegeneinander bildet.

## Beschreibung

Die Erfindung betrifft eine multifunktionale Modulverbindungstruktur, d.h. es wird hierin eine Vorrichtung offenbart, welche eine kraftschlüssige mechanische Verbindung bereitstellt, die darüber hinaus zum bidirektionalen Transfer von elektrischer und thermischer Energie eingesetzt werden kann.

Derzeit finden in konventionellen elektrischen Antriebseinheiten, bestehend aus zumindest einer elektrischen Maschine, zumindest einem (fluidischen) Kühlsystem, zumindest einem leistungselektronischen Modul und weiteren Bauelementen, unterschiedliche Bauelemente Verwendung, um die beiden Funktionen "Erzielen eines mechanischen Anpressdruckes zur Sicherstellung eines guten thermischen Kontaktes" und "Herstellen eines elektrischen Kontaktes" zu erfüllen.

D.h., dass bisher die Aufgabe der elektrischen Verbindung, bspw. von Kabeln und Steckern, bzw. mechanisch unbelasteten elektrischen Steck- oder Schraubverbindern, übernommen wird, während - davon räumlich getrennt - die mechanische Kopplung über mechanische Verbindungselemente wie Schrauben, Bolzen, Klammern usw. erfolgt.

In Bezug auf elektrische Antriebseinheiten ist in [1] eine gekühlte elektrische Baueinheit offenbart, wobei hierbei ein DCB- Substrat mit aufgelötetem Wasserkühler offenbart ist. In [2] ist eine Kombination eines an eine elektrische Maschine angeflanschten leistungselektronischen Moduls mit einer in diesem Modul integrierten Strommesseinrichtung offenbart. In [3] ist ein Inverter in einem Motor integriert. Jedoch ist hierin nicht offenbart, dass elektrische Verbindungselemente auch eine mechanische Aufgabe erfüllen. In [4] ist eine Multipol-Maschine mit angeflanschtem leistungselektronischem Modul gezeigt, wobei hierin keine elektromechanischen Verbindungselemente und keine fluidische Kühlung offenbart sind. In [5] sind elektrische Verbindungsstrukturen gezeigt, wobei zum einen kein fluidischer Kühlkörper und zum anderen keine mechanische Funktionalität der Verbindungsstrukturen offenbart werden. In [6] wird ein Motor mit angeflanschtem Treiber gezeigt, wobei hier die elektrische und mechanische Verbindung getrennt ist und kein Kühlkörper zwischen E-Maschine und Inverter offenbart ist. In [7] ist eine Steckvorrichtung zwischen einer elektrischen Maschine und einem leistungselektronischen Modul gezeigt, wobei die federbelasteten Kontakte lediglich eine elektrische Verbindung herstellen, jedoch keine mechanischen Aufgaben hierbei übernehmen.

### Zitierte Literatur:

[1] Meyer, A. und Schulz-Harder, J.: "Gekühlte elektrische Baueinheit.", Electrovac AG., DE102009022877A1; Deutschland(2009).
[2] Lucot, G. und Guerin, F.: "Power electronic module, method for producing such a module, and rotating electrical machine of a motor vehicle comprising same.", WO 2014/135796A2; Frankreich (2013).
[3] Kenta, S.: "Motor with inverter."; NISSAN MOTOR CO. LTD., JP002014138489A; Japan (2013).
[4] De Filippis, P.: "Rotating electric machine and related packaging method."; SPAL AUTOMOTIVE S.r.l., WO2013/008180A2; Italien (2012).
[5] Dubuc, C., and Thery, L.: "Power interconnecting part for electrical rotating machine."; VALEO EQUIP. ELECTR. MOTEUR, KR102008019600A; Korea (2007).
[6] Matsuda, N. and M. Yamasaki: "Drive apparatus.", US000008456049B2; Japan (2011).
[7] Fromme, G., Hinkelmann, M., Leifert, T. und Mittmann, H.-G.: "Baueinheit aus einer elektrischen Maschine und einer Leistungselektronikeinheit.", EP000000977341A2; Deutschland (1999).

Antriebssysteme, bestehend aus leistungselektronischen Modulen und elektrischen Maschinen, sind, insbesondere die elektromechanische Verbindungsstruktur betreffend, dem Stand der Technik zufolge durch folgende Nachteile gekennzeichnet: Die Verbindungselemente übernehmen jeweils nur eine Aufgabe, d.h. entweder sie dienen der elektrischen oder der mechanischen Verbindung. Dadurch ergibt sich z.B. eine größere räumliche Ausdehnung solcher Verbindungssysteme, insbesondere durch den Raumbedarf für mechanische Elemente, wie bspw. Schrauben, Muttern usw., sowie Anforderungen an die hierbei jeweils erforderliche elektrische Isolation, die weiteren Platzbedarf nach sich zieht bzw. mit sich bringt. Durch den beschriebenen erhöhten Platzbedarf verursachen solche Verbindungssysteme eine große räumliche Ausdehnung und damit ein großes Volumen, bzw. ein hohes Gewicht des Gesamtsystems.

Darüber hinaus bedingen sie einen hohen technischen Aufwand beim Zusammenbau des Systems während der Produktion, d.h. verschiedene Einheiten müssen hierbei getrennt voneinander und sequentiell nacheinander elektrisch oder/und mechanisch kontaktiert werden. Außerdem erfolgt jeweils die elektrische und mechanische Verbindung zwischen leistungselektronischem Modul und E-Maschine über unterschiedliche äußere Flächen des leistungselektronischen Moduls. Klassischerweise erfolgt die elektrische Kontaktierung von oben, d.h. von der der E-Maschine abgewandten Seite, und die thermische Kontaktierung von unten, d.h. von der der E-Maschine zugewandten Seite. Dadurch wird auch innerhalb des leistungselektronischen Moduls mehr Platz verbraucht, da Fläche und Volumen für die mechanische und elektrische Kontaktierung vorgesehen werden muss. Da das Modul dadurch einen höheren Platzverbrauch aufweist, wird auf Modul- und Systemebene eine geringere Leistungsdichte erzielt. Die größere Ausdehnung von konventionellen leistungselektronischen Modulen sowie die größere Leitungslänge der elektrischen Verbindung zwischen E-Maschine und leistungselektronischem Modul verursachen darüber hinaus auch eine höhere elektromagnetische Abstrahlung, deren Bekämpfung zusätzliche Bauelemente (z.B. Filter und Abschirmungen), damit zusätzlichen Bauraum und zusätzliches Gewicht bedeutet.

Besonders hohe Anforderungen an die Kompaktheit werden an elektrische Antriebssysteme und im speziellen an elektrische Antriebssysteme im Bereich der Elektromobilität gestellt. Diese werden durch den Stand der Technik nur unbefriedigend erfüllt.

Ausgangspunkt der hierin vorgestellten Lösung ist die Aufgabe, elektrisch und thermisch aktive Baugruppen derart kompakt und zuverlässig miteinander zu verbinden, sodass ein effizienter elektrischer und thermischer Energieaustausch zwischen ihnen erfolgen kann.

Diese Aufgabe wird mit einer Vorrichtung gemäß den technischen Merkmalen von Patentanspruch 1 gelöst. Hierauf bezogene Nebenansprüche geben weitere vorteilhafte Ausführungsformen wieder bzw. ergeben sich weitere bevorzugte Weiterbildungen aus den darauf bezogenen Unteransprüchen.

Die hierin beschriebene Lösung betrifft mindestens eine multifunktionale Verbindungsstruktur bzw. -anordnung, bspw. in elektrischen Antriebssystemen, die eine gleichzeitige feste Verbindung zwischen mindestens zwei oder mehreren thermisch und/oder elektrisch aktiven Modulen bzw. Bauelementen und/oder einen Austausch thermischer Energie und/oder elektrischer Energie ermöglicht bzw. bereitstellt. Zum Beispiel kann eine solche multifunktionale Verbindungsstruktur bzw. -anordnung eine kraftschlüssige Verbindung zwischen mindestens zwei elektrisch und/oder thermisch aktiven Baugruppen bzw. -elementen bzw. Modulen bereitstellen und zusätzlich kann über die multifunktionale Verbindungsstruktur bzw. -anordnung elektrische Energie transferiert werden sowie über die Verbindung, bspw. eine flächige Verbindung, der mindestens zwei Baugruppen bzw. -elemente bzw. Module thermische Energie ausgetauscht werden.

Ein bevorzugtes Anwendungsgebiet für die hierin beschriebene Erfindung stellen elektrische Antriebssysteme dar, die klassisch aus einer elektrischen Maschine (im Folgenden als E-Maschine bezeichnet), einem Kühlsystem und einer leistungselektronischen Ansteuerung, bestehend aus Leistungshalbleitermodulen und weiteren Bauelementen, bestehen.

Die steigenden Anforderungen an die Integrationsdichte und die Effizienz derartiger Systeme verlangen nach multifunktionalen Komponenten, d.h. Komponenten, die zugleich mehrere Funktionen innerhalb des Systems übernehmen.

Das technische Gebiet umfasst die Struktur (Komponenten und deren Anordnung) von elektrischen Antriebssystemen, wie sie in Windkraftanlagen, Antrieben für industrielle Maschinen und Traktionsantrieben im Bereich der Elektromobilität zum Einsatz kommen. Die Spannungsklasse dieser Systeme liegt im Bereich von 200 V bis 4000 V bei einem Leistungsbereich von 1 kW - 1000 kW.

Die hierin beschriebene Erfindung betrifft eine multifunktionale Struktur in Form von elektromechanischen Verbindungselementen, die die Verbindung zwischen den elektrischen Anschlüssen der E-Maschine und den elektrischen Anschlüssen eines oder mehrerer leistungselektronischer Module herstellen. Diese Verbindungselemente sind hierbei erstmals derart vorgesehen, dass sie bspw. zumindest teilweise die Struktur des Kühlsystems durchdringen, zu diesem elektrisch isoliert, mechanisch jedoch kraftschlüssig verbunden sind. Erstmalig wird hierbei auch vorgesehen, dass das leistungselektronische Modul in dieselbe Richtung eine thermische Ableitung aufweist, in die auch der elektrische Energiefluss zwischen E-Maschine und leistungselektronischem Modul erfolgt. D.h. der Energiefluss durchdringt, bzw. die Energieflüsse durchdringen, dieselbe Oberfläche in Bezug auf das leistungselektronische Modul. Der thermische Energiefluss zwischen leistungselektronischem Modul und dem Kühlsystem der elektrischen Maschine wird dadurch ermöglicht, dass der mechanische Kraftfluss, der erforderlich ist, um das leistungselektronische Modul auf das Kühlsystem der elektrischen Maschine zu pressen, und damit einen thermischen Kontakt mit hoher thermischer Leitfähigkeit herzustellen, durch das multifunktionale elektromechanische Verbindungselement erfolgt. Der Kraftfluss wird auch bei sich, bspw. durch Temperaturänderungen, verändernden Abmessungen der Komponenten durch eine Federwirkung zumindest eines Teils des multifunktionalen elektromechanischen Bauelementes sichergestellt.

Die Anforderung an eine hohe Kompaktheit wird gemäß der Erfindung gelöst durch die wirkungsvolle Kombination von verschiedenen Funktionen, die durch ein einziges Element, das multifunktionale elektromechanische Verbindungselement, übernommen werden. Diese Funktionen sind insbesondere:
- Herstellen einer elektrischen Verbindung zwischen elektrischen Anschlüssen, bzw. elektrischen Kontaktbereichen, der ersten elektrisch und thermisch aktiven Baugruppe und der zweiten elektrisch und thermisch aktiven Baugruppe
- Herstellen einer mechanischen Verbindung zwischen elektrischen Anschlüssen, bzw. elektrischen Kontaktbereichen, der ersten elektrisch und thermisch aktiven Baugruppe und der zweiten elektrisch und thermisch aktiven Baugruppe, die für eine thermische Verbindung zwischen den thermischen Kontaktbereichen der ersten elektrisch und thermisch aktiven Baugruppe und der zweiten elektrisch.und thermisch aktiven Baugruppe sorgt.

Das multifunktionale elektromechanische Verbindungselement ist insbesondere dadurch gekennzeichnet, dass:
- es zumindest ein erstes, elektrisch leitfähiges, mechanisch zumindest teilweise federndes Teilelement aufweist, welches mechanisch und elektrisch mit
- einem zweiten, elektrisch leitfähigen, mechanisch zumindest teilweise starrem Teilelement verbunden ist,
- wobei das multifunktionale elektromechanische Verbindungselement zusätzlich ein elektrisch isolierendes, mechanisch zumindest teilweise starres Element umfassen kann, welches die mechanische Verbindung zwischen dem multifunktionalen elektromechanischen Verbindungselement und der zweiten elektrisch und thermisch aktiven Baugruppe herstellt.

Die erste und die zweite elektrisch und thermisch aktive Baugruppe weist jeweils mindestens eine Baugruppe aus einer Baugruppe der Gruppe von Baugruppen auf, wobei die Gruppe bspw. aufweist:
- Elektrische Maschinen wie Motoren, Generatoren, Transformatoren
- Aktive elektrische und/oder elektronische Bauelemente oder Baugruppen wie leistungselektronische Module, Piezoaktuatoren, optische Strahlungsquellen, elektromagnetische Strahlungsquellen
- Passive elektrische Bauelemente oder Baugruppen wie Kondensatoren, Induktivitäten, elektrische Widerstände, Schaltungsträger

Dabei ist die erste und die zweite elektrisch und thermisch aktive Baugruppe dadurch gekennzeichnet, dass
- der Austausch thermischer Energie zwischen der ersten elektrisch und thermisch aktiven Baugruppe und der zweiten elektrisch und thermisch aktiven Baugruppe technisch notwendig und/oder vorteilhaft ist
- der Austausch elektrischer Energie zwischen der ersten elektrisch und thermisch aktiven Baugruppe und der zweiten elektrisch und thermisch aktiven Baugruppe technisch notwendig ist
- der Austausch elektrischer Energie zwischen der ersten elektrisch und thermisch aktiven Baugruppe und der zweiten elektrisch und thermisch aktiven Baugruppe zumindest von Teilen einer der beiden Baugruppen elektrisch isoliert erfolgen muss

Eine Ausführungsform weist eine Vorrichtung auf, aufweisend: mindestens eine erste und eine zweite thermisch und elektrisch aktive Baugruppe, wobei hierin der Begriff "thermisch und elektrisch aktive Baugruppe" eine Baugruppe beschreibt, die thermische und elektrische Energie jeweils aufnehmen und/oder abgeben kann; wobei beide Baugruppen jeweils eine obere und eine untere Oberfläche aufweisen und wobei sich jeweils die obere und die untere Oberfläche der jeweiligen Baugruppe gegenüberliegen; wobei die zweite Baugruppe derart über der ersten Baugruppe angeordnet ist, dass zumindest teilweise die obere Oberfläche der ersten Baugruppe flächig an die untere Oberfläche der zweiten Baugruppe angrenzt; und wobei thermische Energie durch die beiden aneinander angrenzenden Oberflächen austauschbar ist; und mindestens eine multifunktionale Verbindungsvorrichtung, aufweisend: mindestens drei Bauelemente dadurch gekennzeichnet, dass das erste Bauelement mindestens einen elektrisch isolierenden Körper aufweist; das zweite Bauelement mindestens einen elektrisch leitfähigen Körper aufweist, wobei das erste Bauelement eine elektrische Isolierung zwischen dem zweiten Bauelement und der mindestens einen Baugruppe bildet; das dritte Bauelement mindestens einen elektrisch leitfähigen und mechanisch federnden Körper aufweist; sich das zweite Bauelement durch das erste Bauelement hindurch erstreckt und durch dieses fest oder drehbar und/oder verschiebbar in mindestens einer Dimension mit dem ersten Bauteil verbunden ist; sich das zweite Bauelement zumindest teilweise über das erste Bauelement hinaus erstreckt; das erste Bauelement fest in mindestens eine der beiden Baugruppen eingesetzt ist; sich das erste und das zweite Bauelement zumindest teilweise durch eine der beiden Baugruppen hindurch erstrecken; das dritte Bauelement eine elastische Verbindung zwischen der zweiten Baugruppe und dem zweiten Bauelement bildet; und zumindest die elastische Verbindung eine Vorspannung der beiden Baugruppen gegeneinander bildet.

In einer weiteren Ausführungsform sind die Bauelemente zumindest teilweise jeweils aus mehr als einem Bauteil gebildet, wobei die Bauteile zumindest aus einem Bauteil aus der Gruppe von Bauteilen gebildet sind, wobei die Gruppe aufweist: Metallstift, Gewindestift, Mutter, Unterlegscheibe Federscheibe, Sprengring, Federring.

In einer weiteren Ausführungsform sind die Bauelemente jeweils aus mehr als einem Bauteil gebildet, wobei die dem jeweiligen Element zugordneten Bauteile miteinander kraftschlüssig verbunden sind.

In einer weiteren Ausführungsform weist die erste Baugruppe eine Kühleinheit auf, welche thermische Energie abführt, die über die obere Oberfläche der zweiten Baugruppe eingeführt wird und die zweite Baugruppe zumindest einen Teil der insgesamt von der Kühleinheit abgeführten Energie an der unteren Oberfläche der zweiten Baugruppe bereitstellt.

In einer weiteren Ausführungsform stellt die zweite Baugruppe zumindest einen Teil der von der ersten Baugruppe aufgenommenen elektrischen Energie über mindestens ein multifunktionales Verbindungselement der ersten Baugruppe bereit und wobei die zweite Baugruppe zumindest teilweise mittels elektrischer Leitungen, welche die obere Oberfläche der zweiten Baugruppe durchdringen, mit elektrischer Energie versorgt wird.

In einer weiteren Ausführungsform ist/sind die erste Baugruppe und/oder die zweite Baugruppe mindestens eine Baugruppe aus der Gruppe von Baugruppen, wobei diese Gruppe umfasst: Peltierelemente, optische Strahlungsquellen, thermische Strahlungsquellen, elektromagnetische Strahlungsquellen, Teilchenstrahlungsquellen, elektrische Maschinen, elektrische Vorrichtungen, leistungselektronische Vorrichtungen.

In einer weiteren Ausführungsform weisen die Bauelemente jeweils zumindest teilweise mindestens ein Material aus einer Gruppe von Materialien auf, wobei diese Gruppe umfasst: Kunststoffe, Metalle, Keramiken, Halbleiter, Holz.

Eine weitere Ausführungsform weist eine elektrische Antriebseinheit auf, aufweisend zumindest eine elektrische Maschine, die zumindest teilweise in einem Gehäuse angeordnet ist, zumindest ein Kühlsystem, zumindest ein oder mehrere leistungselektronische Module, die jeweils als Inverter an die elektrische Maschine elektrisch angeschlossen sind, dadurch gekennzeichnet dass: das Kühlsystem zwischen elektrischer Maschine und zumindest einem leistungselektronischen Inverter angeordnet ist und von zumindest einem zweiten Element einer aus einem ersten, einem zweiten und einem dritten Element bestehenden multifunktionalen Verbindungsvorrichtung durchdrungen wird, wobei das erste und das zweite sowie das zweite und das dritte Element mechanisch kraftschlüssig miteinander verbunden sind, wobei das zweite Element der multifunktionalen Verbindungsvorrichtung mit dem Kühlsystem elektrisch isoliert und mechanisch kraftschlüssig mit Hilfe eines ersten Elementes der multifunktionalen Verbindungsvorrichtung verbunden ist, welches das zweite Element von dem Kühlsystem elektrisch isoliert und das zweite Element mit dem Kühlsystem kraftschlüssig verbindet; wobei der dritter Teil der multifunktionalen Verbindungsvorrichtung eine Federwirkung auf die Grenzfläche zwischen der elektrischen Maschine und/oder den Kühlkörper und/oder das zumindest eine leistungselektronische Modul ausübt und somit die elektrischen Maschine und/oder den Kühlkörper und/oder das zumindest eine leistungselektronische Modul aufeinander presst und dadurch einen thermischen Kontakt zwischen der elektrischen Maschine und/oder dem Kühlkörper und/oder dem zumindest einen leistungselektronischen Modul herstellt; und wobei das zweite und das dritte Element der multifunktionalen Verbindungsvorrichtung elektrisch leitend miteinander verbunden sind und das zweite und das dritte Element der multifunktionalen Verbindungsvorrichtung einen elektrischen Kontakt zwischen zumindest einem elektrischen Anschluss der elektrischen Maschine und zumindest einem elektrischen Anschluss des zumindest einen leistungselektronischen Moduls herstellen.

Eine weitere Ausführungsform ist dadurch gekennzeichnet, dass die multifunktionale Verbindungsvorrichtung aus einem Kontaktstift als zweitem Element, einer Isolationshülse als erstem Element sowie einem federndem Befestigungselement als drittem Element besteht, wobei der Kontaktstift aus einem formstabilen, elektrisch leitfähigen Material, vorzugsweise aus einer Kupferlegierung, besteht, wobei die Isolationshülse aus einem formstabilen, elektrisch isolierenden Material, vorzugsweise aus einem faserverstärkten Kunststoff oder einem Keramikwerkstoff, besteht; wobei das Befestigungselement zumindest teilweise aus einem elektrisch leitfähigen Federmaterial, vorzugsweise Federstahl oder/und Federbronze, besteht; wobei das Befestigungselement zumindest teilweise formschlüssig mit dem Kontaktstift verbunden ist und formschlüssig auf der Oberseitenmetallisierung des Keramiksubstrates des leistungselektronischen Moduls aufliegt.

Eine weitere Ausführungsform ist dadurch gekennzeichnet, dass die multifunktionale Verbindungsvorrichtung aus einem Kontaktstift und einer Isolationshülse besteht; wobei der Kontaktstift aus einem zumindest teilweise elastischen, elektrisch leitfähigen Material, vorzugsweise aus Federstahl, besteht; wobei die Isolationshülse aus einem formstabilen, elektrisch isolierenden Material, vorzugsweise aus einem faserverstärkten Kunststoff oder/und einer Keramik, besteht; wobei der Kontaktstift zumindest teilweise formschlüssig auf der Oberseitenmetallisierung des Keramiksubstrates des leistungselektronischen Moduls aufliegt.

Eine weitere Ausführungsform ist dadurch gekennzeichnet, dass die Isolationshülse und/oder der Kontaktstift entlang ihrer jeweils längsten Ausdehnung unterschiedliche Durchmesser aufweisen und miteinander und mit dem Kühlkörper formschlüssig verbunden sind.

Eine weitere Ausführungsform ist dadurch gekennzeichnet, dass das Befestigungselement und/oder die Isolationshülse und/oder der Kontaktstift jeweils aus mehr als einem Teilelement gebildet ist; wobei der Kontaktstift eine Oberflächenperforation, in welche ein erstes Teilelement des Befestigungselementes, welches ein Loch mit einer Oberflächenperforation aufweist, eingreift, und ein zweiter Teil des Befestigungselementes den Radius des Kontaktstiftes zumindest teilweise umspannt und eine mechanische Federwirkung zwischen dem ersten Teilelement des Befestigungselementes und der Oberseitenmetallisierung des Keramiksubstrates ausübt

Eine weitere Ausführungsform ist dadurch gekennzeichnet, dass das keramische Substrat des leistungselektronischen Moduls ein- oder beidseitig mittels DCB-Technik oder/und Dickfilmtechnik mit leitfähigen, lötfähigen, sinterfähigen und klebefähigen elektrisch leitfähigen metallischen Strukturen versehen ist.

Eine weitere Ausführungsform ist dadurch gekennzeichnet, dass der Kühlkörper ein fluidisches Kühlmedium aufweist; wobei das fluidische Kühlmedium zumindest teilweise Wasser aufweist, und wobei das Kühlmedium derart vom Kühlkörper umschlossen ist, dass das auf den Kühlkörper gepresste leistungselektronische Modul nicht in direkten Kontakt zum Kühlmedium steht, oder das Wasser die Unterseite des Moduls direkt umspült, wozu im Kühlkreislauf des Kühlkörpers an der Auflagestelle des leistungselektronischen Moduls zumindest eine Öffnung vorgesehen ist.

Eine weitere Ausführungsform ist dadurch gekennzeichnet, dass die elektrische Maschine mindestens eine elektrische Maschine aus der Gruppe von elektrischen Maschinen ist, wobei die Gruppe umfasst: Lichtmaschine, Startergenerator, Gleichstrommaschine, Synchronmaschine, Asynchronmaschine, permanenterregte Maschine, elektronisch kommutierte Maschine.

Dadurch, dass die Verbindungselemente mehrere Aufgaben gleichzeitig übernehmen, sinkt die benötigte Komponentenanzahl und somit der Platzbedarf und das Systemgewicht. Dies kann für viele Anwendungsbereiche vorteilhaft sein, in denen Bauvolumen mit hohen Kosten verbunden ist, und/oder ein reduziertes Bauvolumen ökologische und/oder ökonomische Vorteile auf Systemebene mit sich bringt. Die Hersteller von Verbindungselementen und/oder von Baugruppen, welche Verbindungselemente beinhalten oder/und an diese angeschlossen werden, können in der Nutzung der Erfindung ein Differenzierungsmerkmal und damit einen Wettbewerbsvorteil erlangen.

Vorteile der hierin beschriebenen Lösung sind u.a.:
- Die multifunktionale Verbindungsvorrichtung vereinigt die Funktionen der mechanischen Befestigung und der Herstellung einer elektrischen Verbindung zwischen elektrischer Maschine und leistungselektronischem Modul in einer Baugruppe, die wesentlich weniger (weniger als 50 %) Platz (Fläche) auf der Kühlfläche, die zumeist die Stirnseite der elektrischen Maschine ist, beansprucht. Daher kann die durch Verwendung der multifunktionalen Verbindungsvorrichtung eingesparte Baufläche für flächenmäßig größere und damit leistungsfähigere leistungselektronische Module verwendet werden.
- Weiterhin entfällt einer der zuvor getrennt ausgeführten Arbeitsgänge des elektrischen und des mechanischen Anschlusses des leistungselektronischen Moduls mit der an die elektrische Maschine angekoppelten Kühleinheit, was zu kürzeren Fertigungszeiten und damit geringeren Herstellungskosten führt.

D.h. Materialersparnis, da statt zwei Baugruppen nur noch eine Baugruppe benötigt wird, die die Aufgaben beider Baugruppen übernimmt.

In einer weiteren Ausführungsform weist die Modulstruktur bspw. mindestens ein Substrat mit mindestens einer ober- und mindestens einer unterseitigen Metallisierung und z.B. einem keramischem Kern mit aufgebrachtem Leistungshalbleiterchip auf, welcher oberseitig mit einem Drahtbond kontaktiert ist. Das Modul befindet sich auf der Außen- oder Innenseite eines Maschinengehäuses einer elektrischen Maschine, z.B. eines Elektromotors, welches über Kühlkanäle für Wasser- oder Luftkühlung verfügt. Die weiteren Komponenten der E-Maschine (z.B. Stator und Rotor) befinden sich in Richtung unterhalb der Kühlkanäle im Bereich des Inneren der E-Maschine. Die Windungsanschlüsse der elektrischen Maschine sind mit den ersten Elementen der Verbindungselemente elektrisch kontaktiert. Darüber hinaus weist bspw. die Modulstruktur einen fluidischen Kühlkörper, ein leistungselektronisches Invertermodul mit Substrat, ein Gehäuse und mindestens einen elektrischen Kontakt zu einem mindestens einen übergeordneten Schaltungsträger auf. Die zweiten Elemente der elektromechanischen Verbindungselemente sind hierbei mittels mechanisch kraftschlüssiger Isolatoren vom Kühlkörper elektrisch isoliert und mit Anschlüssen der E-Maschine elektrisch verbunden, die z.B. unterhalb der Kühlschlangen angeordnet sind. Die E-Maschine verfügt dabei über eine Wandung, die mit dem Kühlkörper verbunden ist. Der Kühlkörper kann daher auch als Rückplatte der E-Maschine fungieren und kann Teile dieser (z.B. Lager etc.) tragen oder/und Teil dieser sein. Die Kühlschlangen kühlen vorzugsweise sowohl den Inverter als auch die E-Maschine. Anzumerken ist, dass sowohl ein mechanischer Kraftfluss zum Anpressen des Inverters auf den Kühlkörper, wie auch ein elektrischer Energiefluss und ein thermischer Fluss, vorzugsweise senkrecht zur Kühlkörperoberfläche, (mit u.U. unterschiedlichem Richtungssinn) erfolgt und die elektromechanischen Verbindungselemente den Kühlkörper durchdringen. Die Anschlüsse der Maschinenwicklungen sind durch lösbare oder unlösbare elektrische Verbindung mit den zweiten Elementen der elektromechanischen Verbindungselemente kontaktiert.

In einer weiteren Ausführungsform weist die Modulstruktur keine Kontaktelemente und/oder Kontaktstifte auf. Hierbei umfasst ein Modulrahmen das Modulsubstrat, bestehend bspw. aus einer Keramik und mindestens einer oberflächlichen, strukturierten Metallisierung. Über bzw. auf dieser Metallisierung sind mittels Löt-, Kleb- oder Sinterverbindung z.B. Leistungshalbleiter aufgebracht bzw. befestigt, welche auf ihrer Oberseite mittels jeweils mindestens eines Drahtbonds kontaktiert sind. Mit der Metallisierung elektrisch kontaktiert ist bspw. ebenfalls mindestens ein keramischer Zwischenkreiskondensator. Einbuchtungen im Gehäuserahmen geben metallisierte Zonen des Substrates frei und erlauben deren Kontaktierung von außen mit Kontaktelementen. In Richtung übergeordnetem Schaltungsträger erfolgt die Kontaktierung über auf die Metallisierung mittels Lötung, Klebung oder Sinterung aufgebrachter Stiftkontakte.

In einer weiteren Ausführungsform, um eine direkte elektromechanische Verbindung zwischen elektromechanischem Verbindungselement und der Oberflächenmetallisierung des Substrates zu ermöglichen, verfügt der Modulrahmen (z.B. das Gehäuse) über Einbuchtungen an den Stellen, an denen diese Verbindung gewünscht ist. Der vom Modulrahmen eingeschlossene Bereich ist dann bspw. durch eine Passivierung, wie bspw. Epoxidlack, Silikongel etc., vor schädlichen Umwelteinflüssen geschützt. Aus dem Modulrahmen herausragende Teile der Oberflächenmetallisierung sind bspw. ebenso wie die elektromechanischen Verbindungselemente durch eine gasdichte metallische Versiegelung, beziehungsweise eine elektrisch leitfähige Oberflächenveredelung, wie z.B. Nickel, Gold, Silber usw., vor (Kontakt-) Korrosion geschützt.

Erfindungsgemäß stellen die Kontaktelemente mindestens einen elektrischen Kontakt zwischen einem Kontaktstift und der Oberflächenmetallisierung des Modulsubstrates bereit. Darüber hinaus wird ein mechanischer Anpressdruck zwischen der Metallisierung des Modulsubstrates und dem Gehäuse der elektrischen Maschine bereitgestellt, sowie ein thermischer Kontakt zwischen der Metallisierung des Modulsubstrates und dem Gehäuse der elektrischen Maschine. Somit übernehmen die Kontaktstifte folgende kombinierte Aufgaben, welche derzeit typischerweise nicht zusammen gelöst werden: Eine elektrische Verbindung zwischen Wicklungen der elektrischen Maschine und dem jeweiligen Verbindungselement des Leistungselektronikmoduls sowie die Aufnahme mechanischer Zug-, Biege- und Druckbelastung zwischen der auf das Maschinengehäuse wirkenden Isolierbuchse und dem auf das Leistungselektronikmodul wirkenden Verbindungselement.

Die Kontaktstifte können hierbei bspw. einen runden, ovalen, rautenförmigen, trapezförmigen, dreieckigen, viereckigen, fünfeckigen, sechseckigen, siebeneckigen, achteckigen oder vieleckigen, d.h. polygonen, oder einen anderen beliebigen freiförmigen Querschnitt bzw. Grundfläche haben und können mit einem Außengewinde oder einer ähnlichen oberflächlichen Perforierung oder Strukturierung ausgestattet sein.

In einer weiteren Ausführungsform können die Querschnitte der Kontaktstifte aufweisen: rechteckig, vieleckig bzw. polygon, sowie rund und zumindest teilweise mit und/oder ohne Oberflächenrauigkeit, bzw. Gewinde oder einer Strukturierung.

In einer weiteren Ausführungsform bestehen die Kontaktelemente aus einem auf Druck und Zug belastbaren Metall und wirken auf eine vergleichsweise dicke, z:B. bis 300 µm dicke, Metallisierung auf einem DCB-Substrat. Da diese Metallisierung auch gleichzeitig als elektrischer Ableiter dient, vereinigt auch sie die Aufgaben der elektrischen Stromleitung und mechanischen Kraftweiterleitung. Die Metallisierung zur elektrischen Kontaktierung wird auf der Oberseite des Substrates benötigt. In diesem Bereich kann die Metallisierung auch mechanische Zugbelastung aufnehmen, die durch das Aufpressen auf den Kühlkörper hervorgerufen wird.

Mittels der hierin beschriebenen Ausführungsformen stellen elektrische und mechanische Kontaktierung eines Leistungselektronikmoduls über ein oder mehrere Elemente jeweils die beiden Funktionalitäten einer elektrischen und einer mechanischen Verbindung bereit. Dabei wird der mechanische Druck genutzt, um eine thermische Verbindung zwischen Modulsubstrat und einem Kühlkörper bereitzustellen. Als Kühlkörper dient hierzu entweder das Maschinengehäuse oder das Maschinengehäuse ist als (z.B. fluidischer) Kühler ausgestaltet oder ein Kühlkörper ist zwischen elektrischer Maschine und leistungselektronischem Modul angeordnet. Die Flussrichtungsorientierungen des thermischen und des elektrischen Flusses liegen parallel und die Flüsse durchdringen jeweils die gleiche Modulseite. Der elektrische Energiefluss durchdringt den Kühlkörper in geeigneten Aussparungen, bzw. ist durch Isolatoren elektrisch zum Kühlkörper isoliert.

Hieraus ergeben sich Kostenvorteile gegenüber herkömmlicher Kontaktierung, bei der mechanische und elektrische Kontaktierung über getrennte Elemente erfolgt. Dies resultiert u.a. aus einem geringeren Materialaufwand, d.h. es muss nur eines statt mehrerer Elemente verbaut werden, einem geringeren Montageaufwand, da eine verringerte Anzahl bereitzustellender Verbindungen erforderlich ist, und weniger arbeitsintensiver Montageschritte, wie bspw. Schrauben, Stecken usw.. Außerdem wird ein geringerer Platzbedarf für die Verbindung benötigt, wodurch entweder eine höhere Leistungsdichte oder eine höhere Effizienz durch verbesserte Kühlung erzielt wird, sowie kürzere Leitungslängen möglich werden.

Somit kann eine Erhöhung der Systemleistungsdichte durch Verringerung des Platzbedarfes von Kontaktierungselementen erreicht werden, da die Aufgaben der elektrischen und mechanischen Kontaktierung durch ein einziges Element, beziehungsweise eine Elementkombination erlangt wird. Darüber hinaus wird die Reduzierung des Leistungsgewichtes durch eine Verringerung der Bauelementanzahl erzielt, sowie eine Reduzierung der Produktionskosten von leistungselektronischen Antriebssystemen durch reduzierten Montageaufwand, da weniger Schraub- und Steckverbindungen notwendig sind. Des Weiteren wird die Reduzierung der elektromagnetischen Abstrahlung ermöglicht.

In einer Ausführungsform weist die Modulverbindungsstruktur ein Hauptsubstrat des Leistungselektronikmoduls auf, bestehend bspw. aus einer Keramik oder einem organischen Schaltungsträger, mit einer Oberflächenmetallisierung welche durch einen oder mehrere Kontaktstifte auf einen zumindest teilweise planen Teil eines Maschinengehäuses gezogen/gedrückt wird. Die Kontaktstifte übernehmen hierbei sowohl die elektrische Kontaktierung als auch die mechanische Befestigung der Module auf dem Maschinengehäuse. Die elektrische Kontaktierung und die thermische Kontaktierung erfolgen bspw. in gleicher räumlicher Richtung und durch ein oder mehrere Elemente, die gleichzeitig diese beiden Aufgaben übernehmen.

Alle hierin beschriebenen Ausgestaltungsformen der erfindungsgemäßen Modulverbindungstruktur können jeweils einzeln oder in Kombination mit einer anderen hier genannten Ausgestaltungsform verwendet bzw. gebildet werden.

In einer weiteren Ausführungsform kann ein Verbindungs- bzw. Befestigungselement aus einem metallischen Blech gebildet sein, welches den Kontaktstift an mindestens zwei Stellen elektrisch und mechanisch berührt bzw. daran angrenzt bzw. kontaktiert. Es verfügt dabei über mindestens ein federndes bzw. flexibles Teilstück, welches sich formschlüssig mit dem Kontaktstift verbindet und durch dessen Federkraft mechanischen Druck auf die Oberflächenmetallisierung des Substrates ausübt. Mindestens ein zweites Teilstück des Befestigungselementes überträgt Zug auf den Kontaktstift und mindestens ein drittes Element des Befestigungselementes kann eine zusätzliche Federwirkung entfalten.

In einer weiteren Ausführungsform ist das Befestigungselement bspw. durch Lötung, Klebung oder ein Sinterverfahren fest mit der Oberflächenmetallisierung des Modulsubstrates verbunden. Der federnde Teil, welcher mechanisch und elektrisch zum Kontaktstift kontaktiert bzw. damit verbunden ist, befindet sich hierbei auf einer Seite des Moduls. Das Befestigungselement wird bspw. aus mindestens einem Federstahlelement mit einer hohen elektrischen Leitfähigkeit bereitgestellt.

In einer weiteren Ausführungsform verfügt das Befestigungselement über zwei parallele Schlitze und einen Bereich, der bspw. als Vieleck ausgebildet ist. Wird das Befestigungselement auf den Kontaktstift aufgeschoben, so biegt dieser einen Teil des Befestigungselementes und übt somit einen Druck aus.

In einer weiteren Ausführungsform kann das Befestigungselement aus einem metallischen Blech bestehen, welches den Kontaktstift an mindestens zwei Stellen elektrisch und mechanisch berührt, wobei sich diese beiden Berührungsstellen zwischen dem Kontaktstift und je einem federnden Element des Befestigungselementes befinden. Um eine hohe Anpresskraft zu übertragen, kommt ein elektrisch isolierendes Druckelement zum Einsatz, welches Teil des Befestigungselementes sein kann.

In einer weiteren Ausführungsform kann die erforderliche Anpresskraft auch durch eine auf einen mit Gewinde versehenen Kontaktstift aufgeschraubte Gewindemutter aufgebracht werden, welche auf ein Federelement, zum Beispiel eine Federscheibe, wirkt. Statt eines Gewindes kann auch eine mechanische Form genutzt werden, die der eines Bajonettverschlusses entspricht oder an diese angelehnt ist.

In einer weiteren Ausführungsform wird die Federkraft nicht durch ein zusätzliches Kontaktierungselement aufgebracht, sondern durch einen mit einer Federeigenschaft versehenen Teil des Kontaktstiftes hervorgerufen. Bspw. weist der Kontaktstift hierzu einen rechteckigen Querschnitt auf, aus welchem das Federelement durch Scheren und Biegen hergestellt wird.

In einer weiteren Ausführungsform kann das Federelement auch so gebogen sein, das es mit einer runden Seite in Richtung Oberflächenmetallisierung des Modulsubstrates kontaktiert. Die Federn des Kontaktstiftes werden jeweils beim Bestücken des Moduls auf das Maschinengehäuse durch das bzw. mittels des Substrats so gebogen, dass die Modulbestückung möglich ist. Hat das Modul die Maschinengehäuseoberfläche erreicht, schnappen bzw. bewegen sich die Federteile in ihre Ausgangsposition zurück und üben einen Anpressdruck auf das Modul aus. Der echteckige Querschnitt ist insbesondere geeignet, um mechanisch einen vorgegebenen Richtungssinn des Modules in Bezug auf die Orientierung des Kühlkörpers sicherzustellen.

In einer weiteren Ausführungsform sind eines oder mehrere Löcher im keramischen Substrat gebildet, durch die der jeweils entsprechende Kontaktstift zumindest teilweise hindurchragt.

In einer weiteren Ausführungsform ist dabei der Kontaktstift mit einem Gewinde versehen und eine Mutter kann verwendet werden, um über Kraftausübung auf die ebenfalls mit einem Loch versehene Oberflächenmetallisierung des Substrates dieses mit mindestens einer Unterseitenmetallisierung auf den Kühlkörper, z.B. Gehäuse einer elektrischen Maschine, zu pressen. Gleichzeitig erfolgt über den beschriebenen Weg auch die Stromzuleitung von einem elektrischen Maschinenanschluss, z.B. Wicklungsanschluss, zum Modul. Die Spannungsversorgung und die Informationsübertragung, wie z.B. Gateansteuerung, werden hierbei z.B. über Pins bereitgestellt.

In einer weiteren Ausführungsform ist/sind der eine Kontaktstift oder die mehreren Kontaktstifte jeweils mit einem Gewinde oder mehreren Gewinden versehen. Hierbei weist der Kontaktstift, sowie die Isolationsbuchse unterschiedliche Durchmesser auf. Die Mutter wirkt auf einen Anpressdruckverteiler, der aus elektrisch leitfähigem Material, bspw. einer Kupferlegierung besteht bzw. gebildet ist. Dieser verteilt den Anpressdruck auf Druckauflagen, welche aus einem elektrisch leitfähigen oder einem elektrisch nicht leitfähigen Material bestehen. Diese Verteilung des Anpressdruckes sorgt für eine flächige Auflage der unteren Metallisierung auf dem Kühlkörper und damit für einen Wärmetransport bzw. -leitung.

In einer weiteren Ausführungsform wird ein Teil des Kontaktstiftes als zweiteiliges Federelement genutzt. Dieses wird bei der Modulmontage so gebogen, dass der Umfang des Querschnitts von dadurch nicht wesentlich erhöht bzw. vergrößert wird und der Kontaktstift durch das im Keramiksubstrat befindliche Loch eingeführt werden kann. Nähert sich die metallisierte Unterseite des Substrates dem Kühlkörper, so schnappen die Federelemente des Kontaktstiftes auf. Dies stellt einen elektrischen Kontakt her und presst das Substrat mechanisch auf den Kühlkörper. Der rechteckige Querschnitt des Kontaktelementes in Verbindung mit einer rechteckigen Aussparung im Substrat sorgt darüber hinaus für eine definierte Orientierung des Moduls auf der Kühlkörperebene. Dies ist von Vorteil, wenn mehrere Module auf einen Kühlkörper montiert werden sollen und diese Module über Pins mit einem übergeordneten Schaltungsträger verbunden werden sollen.

In einer weiteren Ausführungsform kann der Kontaktstift aus Federstahl oder teilweise aus Federstahl gebildet sein. In einer weiteren Ausführungsform kann der Kontaktstift mit einer Oberflächenrauigkeit, bspw. Riffelung, Gewinde usw., zur besseren Haftung des Verbindungselementes beziehungsweise des Schraubverbinders, gebildet sein. In einer weiteren Ausführungsform kann eine Oberflächenvergütung, bspw. mit einem Edelmetall, bzw. Nickel, der Metallisierungen des Modulsubstrates und sowie der Kontaktstiftteile und der Kontaktelemente erfolgen. In einer weiteren Ausführungsform kann die Formung der Kontaktstifte mit integriertem Federelement aus einem einzelnen Werkstück erfolgen. In einer weiteren Ausführungsform wird die elektrische Kontaktierung beziehungsweise die Applikation von Anpresskraft nicht direkt auf die Oberflächenmetallisierung des Substrates ausgeübt, sondern an ein mit dem Substrat elektrisch und mechanisch fest verbundenes Element, welches Federcharakter haben kann bzw. wie eine Feder wirkt.

In einer weiteren Ausführungsform kommen neben Maschinengehäusen als thermische Senke, d.h. Kühlkörper, auch klassische Kühlkörper in Frage, d.h. Anpressen des Moduls auf einen metallischen Körper, der zur Entwärmung dient und durch den, mittels Isolatoren galvanisch getrennt, die Stromzu- oder -abführung zum Modul mittels Kontaktstiften erfolgt, die gleichzeitig auch zur Erzielung einer mechanischen Anpresskraft genutzt werden.

In einer weiteren Ausführungsform kann statt eines fluidischen Kühlkörpers auch ein Luftkühlkörper eingesetzt werden, der vorzugsweise Kühlrippen aufweist, die sich nicht zwischen E-Maschine und leistungselektronischem Modul, sondern um den Umfang der E-Maschine herum erstrecken. Der zwischen der E-Maschine und dem leistungselektronischen Modul angeordnete Teil des Kühlkörpers dient somit vornehmlich dem Wärmeabtransport hin zu den Kühlrippen.

Definition hierin verwendeter folgender Begriffe:

Der hierin verwendete Begriff "fest verbunden" definiert mindestens eine Verbindung aus der Gruppe von Verbindungen, wobei die Gruppe umfasst: kraft-, form- oder stoffschlüssig.

Die Verbindungstechnik beschreibt die Methoden des Zusammensetzens von technischen Gebilden (Maschinen, Anlagen, Apparate, Geräte und moderne Bauwerke) aus ihren Einzelteilen. In der Regel handelt es sich um feste Verbindungen. Die Verbindungen können lösbar oder nicht lösbar sein. Lösbare Verbindungen lassen sich durch Umkehr des Verbindungsvorganges wieder trennen. Nicht lösbare Verbindungen sind nur durch Zerstören zumindest der Verbindung trennbar.

Die Einteilung nach physikalischen Wirkprinzipien lautet: formschlüssig, kraftschlüssig und stoffschlüssig.

Formschlüssige Verbindungen entstehen durch das Ineinandergreifen von mindestens zwei Verbindungspartnern. Dadurch können sich die Verbindungspartner auch ohne oder bei unterbrochener Kraftübertragung nicht lösen. Anders ausgedrückt ist bei einer formschlüssigen Verbindung der eine Verbindungspartner dem anderen im Weg. Bei Betriebsbelastung wirken Druckkräfte normal, das heißt rechtwinklig zu den Flächen der Verbindungspartner. Solche "Sperrungen" kommen in mindestens einer Richtung vor. Ist ein zweites homogenes Flächenpaar gegenüber angeordnet, ist auch die Gegenrichtung gesperrt. Besteht das Paar aus zwei zueinander koaxialen Zylinderflächen, so besteht Formschluss in allen Richtungen der zur Zylinderachse senkrechten Ebene. Ein Beispiel hierfür ist der in ein Loch gesteckte Stift, der wieder herausnehmbar ist. Das Loch ist vorteilhaft ein Sackloch, damit der Stift nicht durchfallen kann. Dabei kommt ein einseitiger Formschluss in Axialrichtung hinzu. Stiftartige Verbindungselemente sind auch Niete und Schrauben, wobei Schraubenverbindungen in der Regel sowohl form- als auch kraftschlüssig sind.

Primär sind nur zwei Bauteile formschlüssig miteinander zu verbinden, was aber oft mit Hilfe eines dritten Teils - des speziellen Verbindungselements - verwirklicht wird. Beispiel ist hierbei u.a. die Verbindung zweier sich überlappender Blechränder mittels Nieten oder Schrauben. Der Formschluss ist außer in der Blechebene auch senkrecht dazu herzustellen. Die Bleche sollen aufeinander gehalten werden, und die Verbindungselemente sollen nicht herausfallen. Zu diesem Zweck haben die Niete beiderseits Köpfe. Die Schraube hat ihren Kopf, und gegenüber befindet sich die Mutter (falls die Schraube nicht ins Blech geschraubt ist).

Bei dünnen Blechen oder großen Kräften zwischen den Blechen in Richtung ihrer Ebenen besteht die Gefahr plastischer Verformung oder Zerstörung an den Lochrändern der Bleche (Lochleibung) und der Scherung in den Stiften. Blechverbindungen werden daher in der Regel zusätzlich mit Kraftschluss versehen oder sogar ausschließlich so ausgelegt, dass der Kraftschluss allein der Beanspruchung widersteht. Die Nieten und Schrauben werden axial elastisch gedehnt, was durch Schrumpfen nach dem Warmnieten beziehungsweise durch festes Anziehen der Schrauben geschieht.

Weitere Beispiele für lösbare Verbindung sind: Nut-, bzw. Feder-Verbindung, Passfeder, Reißverschluss, Schwalbenschwanzverbindung, Verbindungsbeschlag und Zahnkupplung

Weitere Beispiele für nicht lösbare Verbindung sind: Durchsetzfügen und Heißverstemmen

Kraftschluss bzw. Reibschluss bzw. kraftschlüssige Verbindungen setzen eine Normal-Kraft auf die miteinander zu verbindenden Flächen voraus. Ihre gegenseitige Verschiebung ist verhindert, solange die durch die Haftreibung bewirkte Gegen-Kraft nicht überschritten wird. Der Kraft-beziehungsweise Reibschluss ist verloren und die Flächen rutschen aufeinander, wenn die tangential wirkende Last-Kraft größer als die Haftreibungs-Kraft ist.

Kraftschluss ist die Ursache für das Selbsthemmen von belasteten Keilen oder Schrauben. Die Haftreibung zwischen den Wirkflächen verhindert, dass der Keil herausrutscht oder sich die Schraube zu drehen beginnt. Schrauben werden deshalb fest angezogen, auch wenn ihre Vorspannung nicht zur Erzeugung eines Kraftschlusses zwischen den von ihnen verbundenen Teilen (zum Beispiel in einer Blechverbindung, siehe oben) benötigt wird. Das Klemmen ist ebenfalls ein Kraftschluss. Auch Schraubverbindungen zählen zu den kraftschlüssigen Verbindungen.

Stoffschlüssige Verbindungen werden alle Verbindungen genannt, bei denen die Verbindungspartner durch atomare oder molekulare Kräfte zusammengehalten werden. Sie sind gleichzeitig nicht lösbare Verbindungen, die sich nur durch Zerstörung der Verbindungsmittel trennen lassen: Löten, Schweißen, Kleben, Vulkanisieren.

Eine elastische Verbindung beschreibt hierin gemäß dem Begriff Elastizität die Eigenschaft eines Körpers oder Werkstoffes, unter Krafteinwirkung seine Form zu verändern und bei Wegfall der einwirkenden Kraft in die Ursprungsform zurückzukehren (Beispiel: Sprungfeder). Hierin ist dabei das linear-elastische Verhalten gemeint, das durch das Hookesche Gesetz beschrieben wird.

Definitionen hierin verwendeter Begriffe:
- Elektrische Antriebseinheit, aufweisend mindestens eine elektrischen Maschine und eine leistungselektronische Vorrichtung, welche vorzugsweise zumindest ein leistungselektronisches Modul aufweist. Die leistungselektronische Vorrichtung verbindet dabei bspw. elektrisch die elektrische Maschine mit mindestens einer elektrischen Energiequelle oder Energiesenke oder mindestens einer Einheit, die sowohl als Energiequelle wie auch als Energiesenke genutzt bzw. verwendet werden kann.
- Elektrische Maschine, kurz E-Maschine, eine auf der Kraftwirkung des durch Stromfluss hervorgerufenen magnetischen Feldes basierende Maschine, die zu einem bestimmten Zeitpunkt elektrische Energie in mechanische Energie bzw. mechanische Energie in elektrische Energie umwandeln kann oder elektrische Energie in elektrische Energie transformiert.
- Mindestens ein Gehäuse, aufweisend zumindest einen Teil eines Systems wie beispielsweise mindestens eine elektrische Maschine oder/und mindestens ein leistungselektronisches Modul. Das Gehäuse kann zumindest teilweise aus mindestens einem elektrisch leitfähigem Material (wie bspw. Stahl, Kupfer, Messing, Silber, Gold oder einer Legierung hiervon) oder zumindest teilweise aus mindestens einem elektrisch nicht leitfähigen Material (wie bspw. einem Kunststoff) bestehen.
- Mindestens ein Kühlsystem, wobei das Kühlsystem Wärme mit Hilfe eines gasförmigen (bspw. Luft, Druckluft) oder fluidischen (bspw. Wasser, Öl) Mediums von einer Wärmequelle abführt, leitet bzw. transferiert. Wärmequellen sind bspw. mindestens eine elektrische Maschine und/oder mindestens ein leistungselektronisches Modul.
- Leistungselektronische Module, aufweisend zumindest ein Substrat (bspw. aufweisend Keramik, organisches Material) auf dem sich zumindest auf einer Seite zumindest eine strukturierte elektrisch leitfähige Schicht befindet, auf der sich zumindest ein leistungselektronischer Halbleiter befindet. Dieser ist mit der elektrisch leitfähigen Schicht elektrisch leitfähig gekoppelt und mit dem Substrat thermisch leitfähig gekoppelt. Das Modul weist mindestens einen elektrischen Kontakt auf, der dem Energieaustausch und dem Informationsaustausch (Signalübertragung) dient. Das Modul wird bspw. durch mindestens ein Gehäuse eingefasst, welches zumindest eine Öffnung aufweisen kann, durch die zumindest ein Teil des Substrates herausragt und das zumindest zwei Öffnungen aufweist, durch welche elektrische Kontakte geführt werden können.
- Inverter, aufweisend mehr als einen leistungselektronischen Halbleiter, sowie zumindest ein passives elektrisches Bauteil wie bspw. mindestens einen Kondensator, mindestens eine Induktivität und/oder mindestens ein ähnliches elektrisch passives Bauteil. Vorzugsweise sind leistungselektronische Halbleiter zumindest teilweise in einem oder mehreren leistungselektronischen Modulen zusammengefasst.
- Multifunktionales elektromechanisches Verbindungselement, bestehend aus
   - einem ersten Element, aufweisend ein Buchsenelement bzw. Isolationshülse aus mindestens einem Isolierwerkstoff;
   - einem zweiten Element bestehend aus einem Kontaktstift; und
   - einem dritten Element mit mechanischer Federwirkung.

Vorteilhaft können alle Ausführungsformen der hierin beschriebenen und beanspruchten Vorrichtung in Kombination mit einer oder mehreren der hierin genannten und beschriebenen Ausführungsformen realisiert werden.

Weitere Ausführungsformen, deren Ausgestaltung sowie einige der Vorteile, die mit diesen und weiteren Ausführungsformen verbunden sind, werden durch die nachfolgende ausführliche Beschreibung unter Bezug auf die begleitenden Figuren besser verständlich. Die Figuren sind lediglich schematische Darstellungen von Ausführungsformen der Erfindung.

### Figurenbeschreibung:

Dabei zeigen
- **Fig. 1**: eine schematische Querschnittsansicht einer Ausführungsform;
- **Fig. 2-1**: eine schematische Draufsicht einer weiteren Ausführungsform;
- **Fig. 2-2**: eine schematische Querschnittsansicht einer Ausführungsform;

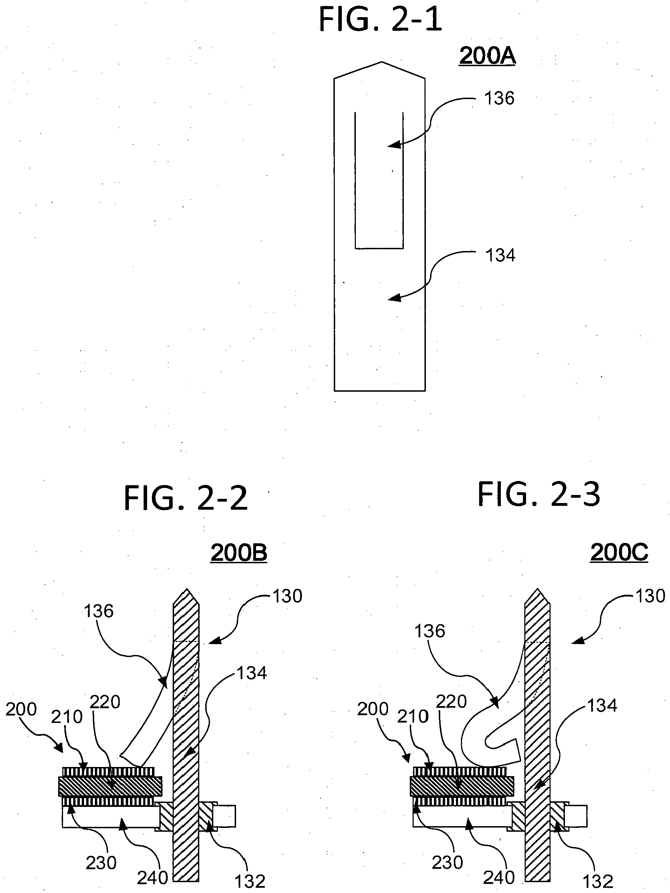

- **Fig. 2-3**: eine schematische Querschnittsansicht einer Ausführungsform;

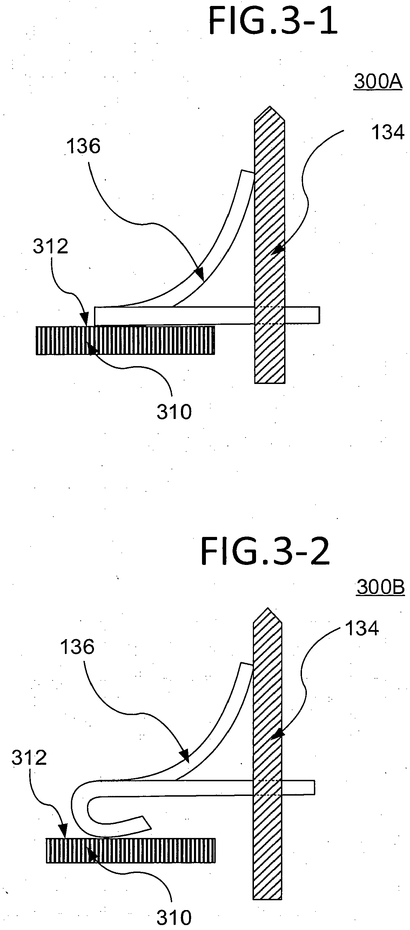

- **Fig. 3-1**: eine schematische Querschnittsansicht einer Ausführungsform;
- **Fig. 3-2**: eine schematische Querschnittsansicht einer Ausführungsform

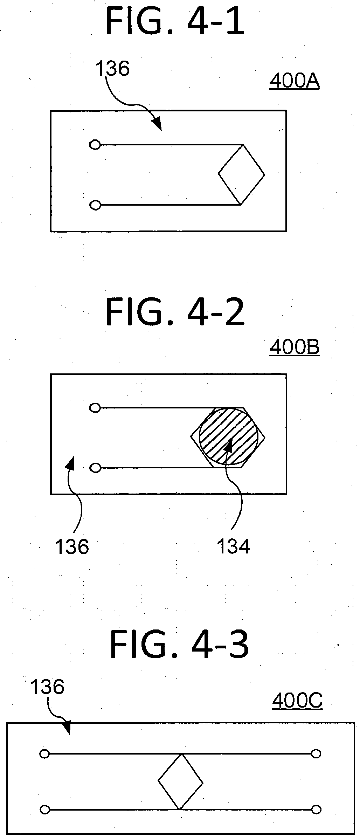

- **Fig. 4-1**: eine schematische Draufsicht einer weiteren Ausführungsform
- **Fig. 4-2**: eine schematische Draufsicht einer weiteren Ausführungsform
- **Fig. 4-3**: eine schematische Draufsicht einer weiteren Ausführungsform

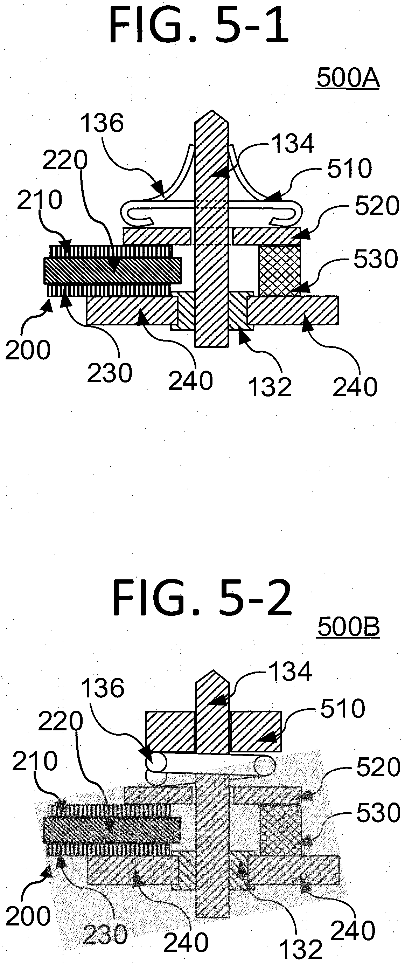

- **Fig. 5-1**: eine schematische Querschnittsansicht einer Ausführungsform
- **Fig. 5-2**: eine schematische Querschnittsansicht einer Ausführungsform
- **Fig. 2**: eine schematische Draufsicht einer weiteren Ausführungsform;
- **Fig. 3**: eine schematische Querschnittsansicht einer weiteren Ausführungsform;
- **Fig. 4**: eine schematische Querschnittsansicht einer weiteren Ausführungsform;
- **Fig. 5**: eine schematische Querschnittsansicht einer weiteren Ausführungsform;

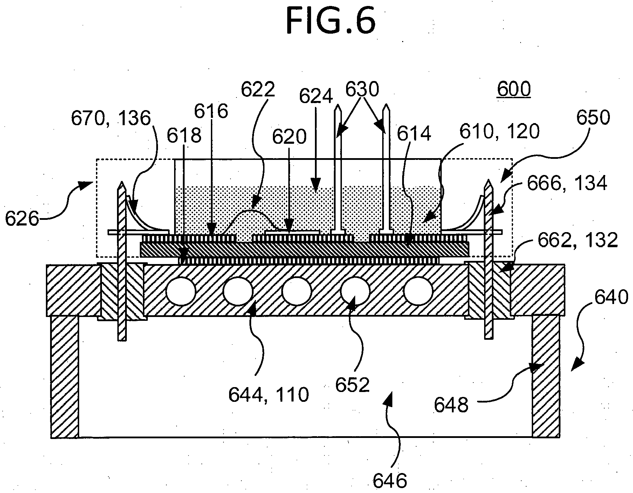

- **Fig. 6**: eine schematische Querschnittsansicht einer weiteren Ausführungsform;

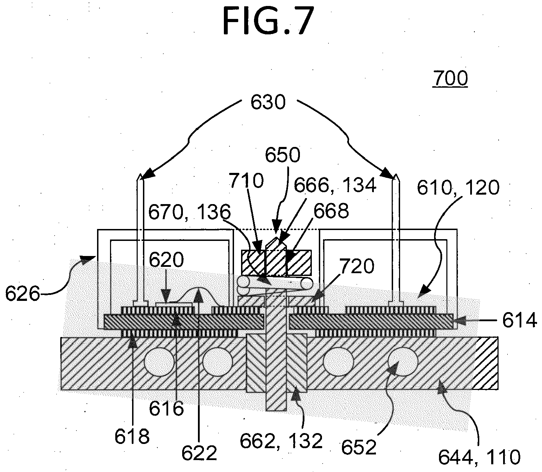

- **Fig. 7**: eine schematische Querschnittsansicht einer weiteren Ausführungsform;

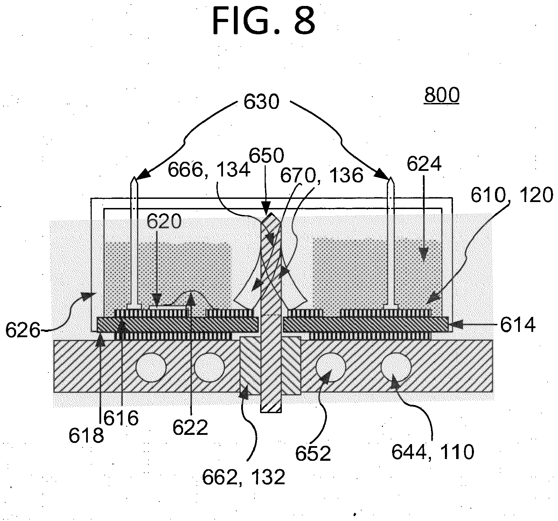

- **Fig. 8**: eine schematische Querschnittsansicht einer weiteren Ausführungsform; und

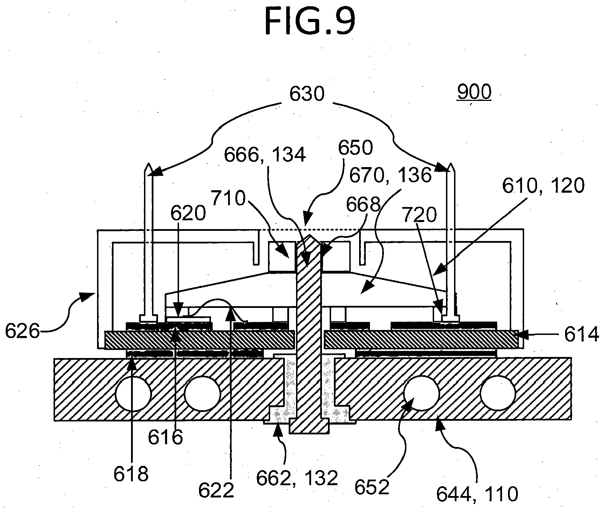

- **Fig. 9**: eine schematische Querschnittsansicht einer weiteren Ausführungsform.

Im Folgenden beschreiben gleiche Bezugszeichen gleiche Bauteile bzw. -elemente, Vorrichtungen, Anordnungen und/oder Module, wobei diese aus gleichen Materialien gebildet sein können bzw. gleiche chemische bzw. physikalische Eigenschaften aufweisen können.

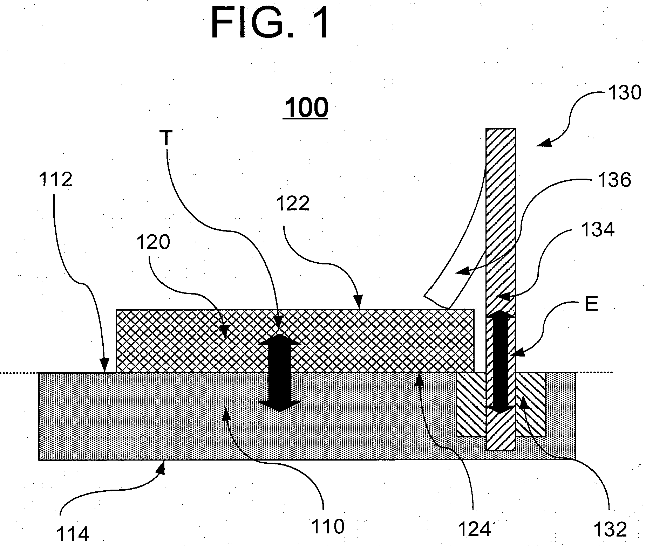

In **Fig. 1** ist eine schematische Darstellung einer Ausführungsform 100 der hierin beschrieben Lösung dargestellt. Die Ausführungsform 100 weist zumindest eine erste thermisch und elektrisch aktive Baugruppe 110 und zumindest eine zweite thermisch und elektrisch aktive Baugruppe 120 auf. Die mindestens eine erste und eine zweite Baugruppe, 110 und 120, können jeweils aus zumindest einem der zuvor genannten Materialien gebildet sein bzw. diese aufweisen. Die mindestens eine erste und eine zweite Baugruppe, 110 und 120, können jeweils aus zumindest einem oder aus mehreren der zuvor genannten elektronisch bzw. elektrisch und/oder thermisch aktiven Bauteile bzw. -elemente bzw. -module gebildet sein bzw. diese aufweisen. Die erste thermisch und elektrisch aktive Baugruppe 110 weist zumindest eine obere Oberfläche 112 und zumindest eine untere Oberfläche 114 auf. Die zweite thermisch und elektrisch aktive Baugruppe 120 weist zumindest eine obere Oberfläche 122 und zumindest eine untere Oberfläche 124 auf. Die mindestens eine erste obere Oberfläche 112 und die mindestens eine untere Oberfläche 124 sind flächig aneinander angrenzend angeordnet. Durch die beiden Oberflächen 112 und 124 kann thermische Energie T ausgetauscht bzw. transferiert werden. Die Vorrichtung 100 weist zusätzlich zumindest eine multifunktionale Verbindungsvorrichtung 130 auf. Die multifunktionale Verbindungsvorrichtung weist zumindest ein erstes Bauelement 132, zumindest eine zweites Bauelement 134 und zumindest ein drittes Bauelement 136 auf. Die Bauelemente, 132, 134 und 136, können jeweils aus zumindest einem der zuvor genannten Materialien gebildet sein bzw. diese aufweisen. Die Bauelemente, 132, 134 und 136, können jeweils aus zumindest einem Element bzw. mehr als einem Element bestehen bzw. gebildet sein. Das erste Bauelement 132 weist mindestens einen elektrisch isolierenden Körper auf und das zweite Bauelement 134 mindestens einen elektrisch leitfähigen Körper. Das erste Bauelement ist derart um das zweite Bauelement 134 angeordnet, dass eine elektrische Isolierung zwischen dem zweiten Bauelement 134 und der mindestens einer Baugruppe, 110 oder/und 120, gebildet wird. Das dritte Bauelement 136 weist mindestens einen elektrisch leitfähigen und mechanisch federnden Körper auf. Das zweite Bauelement 134 erstreckt sich zumindest teilweise durch das erste Bauelement 132 hindurch und ist fest mit dem ersten Bauelement 132 verbunden. Eine feste Verbindung wird hierin gemäß der zuvor beschriebenen Charakteristika dieses Begriffes definiert. Das zweite Bauelement 134 erstreckt sich zumindest teilweise über das erste Bauelement 132 hinaus. Das erste Bauelement 132 ist fest in mindestens eine der beiden Baugruppen, 110 und 120, eingesetzt und bildet dabei eine feste Verbindung gemäß der zuvor beschriebenen Definition dieses Begriffes. Jeweils das erste und das zweite Bauelement, 132 und 134, erstreckt sich zumindest teilweise durch eine der beiden Baugruppen, 110 und 120, hindurch. Das dritte Bauelement 136 bildet eine elastische Verbindung gemäß der zuvor beschriebenen. Definition dieses Begriffes zwischen der zweiten Baugruppe 120 und dem zweiten Bauelement 134. Hierbei bewirkt die elastische Verbindung eine Vorspannung der beiden Baugruppen, 110 und 120, gegeneinander. Die drei Bauelemente können bspw. eine Querschnittsfläche aufweisen, deren Form eine quadratische, rechteckige, viereckige, runde, rautenförmige, ovale, dreieckige bzw. n-eckige, d.h. eine beliebige zweidimensionale Freiform bzw. ein Polygon, aufweist. Die Enden des Körpers des zweiten bzw. des dritten Bauelements, 134 und 136, können flach, spitz, rund, konisch pyramidenförmig und/oder schräg gebildet sein. Außerdem können zum Beispiel darüber hinaus die Kanten des dritten Bauelements 136 und der Baugruppe 120, welche sich beim Verbinden berühren, derart gebildet sein, dass mindestens eine davon schräg gebildet ist, so dass ein Verbinden hierdurch leichter erfolgen kann und/oder die zum Herstellen der Verbindung notwenige mechanische Kraft reduziert wird.

In einer weiteren Ausführungsform können die Bauelemente, 132, 134 und 136, zumindest teilweise jeweils aus mehr als einem Bauteil gebildet sein, wobei die Bauteile zumindest aus einem Bauteil aus der Gruppe von Bauteilen gebildet sind, wobei die Gruppe aufweist: Metallstift, Gewindestift, Mutter, Unterlegscheibe Federscheibe, Sprengring, Federring.

In einer weiteren Ausführungsform können die Bauelemente, 132, 134 und 136, jeweils aus mehr als einem Bauteil gebildet sein, wobei die dem jeweiligen Element zugordneten Bauteile miteinander kraftschlüssig verbunden sind.

In einer weiteren Ausführungsform kann die erste Baugruppe 110 eine Kühleinheit aufweisen, welche thermische Energie T abführt, die zumindest teilweise über die obere Oberfläche 112 der ersten Baugruppe 110 eingeführt wird und die zweite Baugruppe 120 zumindest einen Teil der insgesamt von der Kühleinheit abgeführten Energie T an der unteren Oberfläche 124 der zweiten Baugruppe 120 bereitstellt.

In einer weiteren Ausführungsform kann die zweite Baugruppe 120 zumindest einen Teil der von der ersten Baugruppe 110 aufgenommenen elektrischen Energie E über mindestens ein multifunktionales Verbindungselement 130 der ersten Baugruppe 110 bereitstellen, wobei die zweite Baugruppe 120 zumindest teilweise mittels elektrischer Leitungen, welche die obere Oberfläche (122) der zweiten Baugruppe 120 durchdringen, mit elektrischer Energie und/oder elektrischen Signalen versorgt wird.

In einer weiteren Ausführungsform kann die erste Baugruppe 110 und/oder die zweite Baugruppe 120 mindestens eine Baugruppe aus der Gruppe von Baugruppen sein, wobei diese Gruppe umfasst: Peltierelemente, optische Strahlungsquellen, thermische Strahlungsquellen, elektromagnetische Strahlungsquellen, Teilchenstrahlungsquellen, elektrische Maschinen, leistungselektronische Vorrichtungen, elektrische Vorrichtungen.

In einer weiteren Ausführungsform können die Bauelemente, 132, 134 und 136, jeweils zumindest teilweise mindestens ein Material aus einer Gruppe von Materialien aufweisen, wobei diese Gruppe umfasst: Kunststoffe, Metalle, Keramik, Halbleiter, Holz.

In **Fig. 2-1** ist eine weitere Ausführungsform 200A schematisch dargestellt. In Fig. 2-1 ist eine schematische Draufsicht auf eine weitere Ausführungsform 200A der beiden Bauelemente, 134 und 136, dargestellt. In dieser Ausführungsform sind die beiden Bauelemente, 134 und 136, aus einem Element gebildet. D.h. das federnde mindestens eine dritte Element 136 wird zumindest teilweise innerhalb des zweiten Bauelements 134 gebildet. Hierzu wird zumindest ein Teilbereich oder mehr als zumindest ein Teilbereich des zweiten Bauelements freigelegt bzw. abgetrennt, wobei zumindest ein Bereich mit dem zweiten Bauelement fest verbunden bleibt. Mit anderen Worten, das teilweise Freilegen bzw. Abtrennen des dritten Bauelements 136 von dem zweiten Bauelement 134 wird derart durchgeführt, dass zumindest eine feste Verbindung zwischen dem dritten Bauelement 136 und dem zweiten Bauelement 134 bestehen bleibt. Das teilweise Freilegen bzw. Abtrennen des dritten. Bauelements 136 von dem zweiten Bauelement 134 kann dabei mittels mindestens eines Metallbearbeitungsverfahrens aus der Gruppe von Metallbearbeitungsverfahren durchgeführt werden bzw. erfolgen, wobei diese Gruppe umfasst: Schneiden, Sägen, Stanzen, Laserschneiden, Wasserstrahlschneiden, Ätzen oder eine andere konventionelle Metallbearbeitungstechnik zum Freilegen oder Abtrennen von Bereichen innerhalb einer Metallfläche. Darüber hinaus wird mittels des teilweisen Freilegens bzw. Abtrennens des dritten Bauelements 136 von dem zweiten Bauelement 134 aufgrund der Materialeigenschaften der beiden Bauelemente, 134 und 136, ein federndes bzw. elastisches drittes Bauelement 136 gebildet über welches eine elastische Vorspannung zwischen den mindestens zwei damit zu verbindenden Baugruppen gebildet werden kann.

In **Fig. 2-2** ist eine weitere Ausführungsform 200B in einer schematischen Querschnittsansicht dargestellt. Die Ausführungsform 200B weist mindestens eine Verbindungsstruktur bzw. -anordnung 130 auf, wobei eine solche Verbindungsstruktur bzw. -anordnung 130 mindestens drei Bauelemente, 132, 134 und 136, aufweist. Die mindestens eine Verbindungsstruktur bzw. -anordnung 130 bzw. deren mindestens drei Bauelemente, 132, 134 und 136, können gemäß einer der zuvor genannten Ausführungsformen gebildet sein bzw. aus den hierfür zuvor genannten Materialien gebildet sein bzw. diese aufweisen. Außerdem weisen die mindestens eine Verbindungsstruktur bzw. -anordnung 130 bzw. deren mindestens drei Bauelemente, 132, 134 und 136, gleiche oder ähnliche chemische bzw. physikalische Eigenschaften auf, wie die der bereits zuvor genannten mindestens einen Verbindungsstruktur bzw. -anordnung 130 bzw. deren mindestens drei Bauelemente, 132, 134 und 136. In der Ausführungsform 200B ist die eine Baugruppe 200 beider Baugruppen, 200 und 240, aus mehr als einem Element bzw. Modul gebildet. Ausführungsform 200B weist mindestens eine zweite thermisch und elektrisch aktive Baugruppe 200 auf, die ein Modulsubstrat bestehend aus mindestens drei schichtförmigen, übereinander angeordneten Werkstoffen, 210, 220 und 230, aufweist. Jede der drei schichtförmig angeordneten Werkstoffe, 210, 220 und 230, kann aus mindestens einem elektrisch bzw. thermisch aktiven Material bzw. Bauelement gebildet sein, wobei dieses Bauelement bzw. Material mindestens ein Bauelement bzw. Material ist bzw. daraus gebildet ist. Dabei kann diese Ausführungsform aufweisen zumindest eine Baugruppe 200, aufweisend mindestens drei schichtförmige, übereinander angeordnete Werkstoffe, 210, 220 und 230, mindestens ein Substrat 220 mit mindestens einem Keramikträger, mindestens eine oberseitige Oberflächenmetallisierung 210 und mindestens eine unterseitigen Oberflächenmetallisierung 230, wobei zumindest über einem Bereich der oberseitigen Oberflächenmetallisierung 210 mindestens ein Leistungshalbleiterchip (nicht dargestellt) angeordnet sein kann, der über mindestens eine Drahtbondverbindung (nicht dargestellt) elektrisch leitfähig mit einem Teil der oberseitigen Oberflächenmetallisierung 210 elektrisch gekoppelt ist. Ein derart gebildetes leistungselektronisches Modul (nur teilweise dargestellt) kann bspw. zumindest teilweise von einer Vergussmasse und/oder zumindest teilweise von mindestens einem Modulgehäuse umgeben sein. Darüber hinaus kann ein Kontaktstift oder mehrere Kontaktstifte (nicht dargestellt), auf der oberseitigen Oberflächenmetallisierung 210 des Modulsubstrates 220 aufgebracht sein, um das so gebildete leistungselektronische Modul mit einem übergeordneten Schaltungsträger oder/und einem übergeordneten leistungselektronischen System elektrisch leitfähig zu verbinden. Hierin beschreibt der Begriff "leistungselektronisches Modul" alle elektrisch bzw. elektronisch aktiven Elemente, Bauteile oder Module in jeder vorhergehenden oder noch folgenden Ausführungsform, die nicht zur Verbindungsstruktur bzw. -anordnung 130 gezählt werden oder dazu gehören. Das erste Bauelement 132 der Verbindungsstruktur bzw. -anordnung 130 durchdringt die erste thermisch und elektrisch aktive Baugruppe 240 und ragt über die Baugruppe 240 hinaus. Die erste Baugruppe kann gemäß der zuvor beschrieben Baugruppe 110 gebildet sein. Das zweite Bauelement 134 durchdringt das erste Bauelement 132, wobei das erste Bauelement 132 das zweite Bauelement 134 zumindest elektrisch von der ersten Baugruppe 240 isoliert und das zweite Bauelement 134 mit dem ersten Bauelement 132 fest verbunden ist. Das dritte Bauelement 136 wird gemäß der Ausführungsform 200A gebildet.

In **Fig. 2-3** ist eine schematische Querschnittsansicht einer weiteren Ausführungsform 200C dargestellt. Die Ausführungsform 200C basiert dabei auf den zuvor beschriebenen Ausführungsformen 200A und 200B. D.h. die Materialien bzw. Bauelemente, -gruppen bzw. Module basieren auf den gleichen Materialeigenschaften bzw. sind aus gleichen Baugruppen bzw. -elementen gebildet gemäß mindestens einer zuvor beschriebenen Ausführungsform. Lediglich das dritte Bauelement 136 weist eine unterschiedliche Form auf. Wie in Fig. 2-3 dargestellt ist, ist ein Bereich des dritten Bauelements 136 in Richtung der Verbindungstruktur 130 zumindest teilweise gebogen, d.h. der Radius der Krümmung weist von der Verbindungsstruktur 130 weg. Wobei der gebogene Bereich des dritten Bauelements 136 dem mindestens einen Bereich des dritten Bauelements 136 gegenüberliegend angeordnet ist, der zumindest mit dem zweiten Bauelement 134 verbunden ist. Die Biegung des dritten Bauelements kann auch von der Verbindungstruktur 130 zugewandt erfolgen, d.h. entgegengesetzt der zuvor beschriebenen Biegung.

In **Fig. 3-1** ist eine schematische Querschnittsansicht einer weiteren Ausführungsform 300A dargestellt. Die Ausführungsform 300A zeigt dabei einen Teil einer Verbindungstruktur 130 gemäß der vorhergehenden Beschreibung mit mindestens drei Bauelementen, 132 (nicht dargestellt), 134 und 136. Aus Gründen der Klarheit sind hierbei nur die Bauelemente 134 und 136 dargestellt, sowie eine zweite thermisch und elektrisch aktive Baugruppe 310, wobei die Baugruppe 310 zumindest gemäß einer der zuvor genannten Baugruppen gebildet sein kann. In der Ausführungsform 300A ist in dem zweiten Bauelement 134 eine Öffnung derart gebildet, dass das dritte Bauelement 136 zumindest teilweise darin aufgenommen werden kann bzw. auch das zweite Bauteil 134 durchdringen kann und somit mit dem zweiten Bauteil fest verbunden ist. Das dritte Bauelement 136 weist innerhalb des Bauteils zumindest einen teilweise freigelegten bzw. einen abgetrennten Bereich auf, so dass dieser Teil federnd bzw. elastisch gebildet ist. Dieser teilweise freigelegte bzw. abgetrennte Bereich weist zumindest einen Bereich auf, der mit dem dritten Bauelement elektrisch verbunden ist. Das teilweise Freilegen bzw. Abtrennen eines Bereichs innerhalb des dritten Bauelements 136 kann mittels einer der zuvor genannten Metallbearbeitungstechniken gemäß der zuvor beschriebenen Ausführungsform 200A in Fig. 2-1 durchgeführt werden bzw. erfolgen. Das derart gebildete dritte Bauelement 136 nimmt in dessen dafür gebildeter Öffnung das zweite Bauelement 134 auf, wobei dabei der federnde bzw. elastische freigelegte bzw. abgetrennte Bereich auf die erste Baugruppe 310 eine Vorspannung bildet, wobei dadurch eine Vorspannung an die erste Baugruppe 310 als auch an die mindestens eine darunter angeordnete Baugruppe (nicht dargestellt) gebildet wird. Dabei muss das zweite Bauelement 134 welches in einem ersten Bauelement aufgenommen ist bzw. damit fest verbunden ist, gemäß einer der zuvor beschriebenen Ausführungsformen so angeordnet sein, dass die untere Kante der Öffnung im dritten Bauteil 136, bzw. die Kante der Öffnung die am nächsten zum ersten Bauteil (nicht dargestellt) angeordnet bzw. gebildet ist, im Wesentlichen auf der gleichen Höhe wie die obere Oberfläche 312 der zweiten Baugruppe 310 angeordnet ist bzw. gebildet ist.

In **Fig. 3-2** ist eine schematische Querschnittsansicht einer weiteren Ausführungsform 300B dargestellt. Hierin sind, wie in der oben beschriebenen Ausführungsform 300A, die für diese Ausführungsform wesentlichen Bestandteile dargestellt, wobei auch in dieser Ausführungsform die in den zuvor beschriebenen Ausführungsformen aufgewiesenen Verbindungsstrukturen bzw. -anordnungen, Baugruppen und -elemente bzw. Module verwendet bzw. eingesetzt werden. Wie in der oben beschriebenen Ausführungsform 300A, weist auch die Ausführungsform 300B eine Verbindungsstruktur bzw. -anordnung auf, wobei auch in dieser Ausführungsform 300B, die Bauelemente, 134 und 136, aus zwei einzelnen Bauelementen bestehen, d.h. auch in Ausführungsform 300B weist das mindestens eine dritte Bauelement 136 mindestens eine Öffnung auf, so dass in diese Öffnung das mindestens eine zweite Bauelement 134 zumindest teilweise aufgenommen werden kann bzw. dass das zweite Bauelement 134 auch das dritte Bauelement 136 durchdringen kann und somit mit dem dritten Bauelement fest verbunden ist, so wie gemäß der oben beschriebenen Ausführungsform 300A. Das dritte Bauelement 136 weist zumindest einen teilweise freigelegten bzw. abgetrennten Bereich innerhalb des dritten Bauelements 136 auf, so dass dieser Teil federnd bzw. elastisch gebildet ist, gemäß zumindest einer der zuvor beschriebenen Ausführungsformen. Dieser teilweise freigelegte bzw. abgetrennte Bereich weist zumindest einen Bereich auf, der mit dem zweiten Bauelement verbunden ist. Das teilweise Freilegen bzw. Abtrennen eines Bereichs innerhalb des dritten Bauelements 136 kann mittels einer der zuvor genannten Metallbearbeitungstechniken gemäß der zuvor beschriebenen Ausführungsform 200A in Fig. 2-1 durchgeführt werden bzw. erfolgen. Das zweite Bauelement 134 wird in die dafür derart gebildete Öffnung in dem dritten Bauelement 136 angeordnet, wobei dabei der federnde bzw. elastische, freigelegte bzw. abgetrennte Bereich auf die erste Baugruppe 310 eine Vorspannung bildet, wobei dadurch eine Vorspannung an die erste Baugruppe 310 als auch an die mindestens eine darunter angeordnete Baugruppe (nicht dargestellt) gebildet wird. In dieser Ausführungsform 300B wird eine zusätzliche Vorspannung an die darunter angeordneten Baugruppen, wobei in Fig. 3-2 aus Vereinfachungsgründen nicht alle dargestellt sind, dadurch erzielt, dass ein Bereich des mindestens einen dritten Bauelements 136, der von dem mindestens einen zweiten Bauelement 134 abgewandt ist, gebogen gebildet ist, wobei diese Biegung in Richtung der darunter angeordneten Baugruppen, bspw. Baugruppe 310 und weiteren nicht dargestellten Baugruppen, erfolgt bzw. in diese Richtung ausgeführt ist. Die Biegung kann bspw. eine Rundung auf der von dem mindestens einen dritten Bauelement 134 abgewandten Seiten aufweisen oder einen Knick bzw. einen Falz. Dabei muss das mindestens eine zweite Bauelement 134 welches in einem mindestens einen ersten Bauelement, gemäß einer der zuvor beschriebenen Ausführungsformen, aufgenommen ist bzw. damit fest verbunden ist, gemäß einer der zuvor beschriebenen Ausführungsformen, so angeordnet sein, dass die untere Kante der Öffnung in dem mindestens einen dritten Bauteil 136, bzw. die Kante der Öffnung in dem mindestens einen dritten Bauteil 136, die am nächsten zum ersten Bauteil (nicht dargestellt) angeordnet bzw. gebildet ist, im Wesentlichen auf einer Höhe angeordnet ist, welche der Höhe entspricht, die sich zumindest aus der Höhe der oberen Oberfläche 312 und der Höhe der Biegung zusammensetzt.

In **Fig. 4-1** ist eine schematische Draufsicht einer weiteren Ausführungsform 400A dargestellt. Die Ausführungsform 400A zeigt eine weitere Ausführungsform für das mindestens eine dritte Bauelement 136 in einer der Verbindungsstrukturen bzw. -anordnungen gemäß einer der zuvor beschriebenen Ausführungsformen. Das hierin dargestellte mindestens eine dritte Bauelement 136 weist eine rechteckige Form auf, wobei das Element wie eine Platte bzw. als flacher Körper bzw. wie ein flacher Quader gebildet ist. Innerhalb des dritten Bauelements 136 ist zumindest ein Bereich teilweise freigelegt bzw. davon teilweise abgetrennt, wobei der teilweise freigelegte bzw. teilweise abgetrennte Bereich mindestens einen Bereich aufweist der mit dem mindestens einen dritten Bauelement 136 fest verbunden ist. In der Ausführungsform 400A ist der Bereich, der dem fest verbundenen Bereich gegenüberliegt derart gebildet, dass eine Öffnung gemäß einer Raute bzw. Viereck gebildet ist. Die Öffnung kann durch mindestens ein zweites Bauelement (nicht dargestellt) durchdrungen werden, so dass der teilweise freigelegte bzw. teilweise abgetrennte Bereich innerhalb des mindestens dritten Bauelements 136 in eine Richtung gedrückt wird und somit eine Federwirkung entfaltet. Dabei wird der teilweise freigelegte bzw. teilweise abgetrennte Bereich innerhalb des mindestens dritten Bauelements 136 in die Richtung gedrückt, in die das mindestens eine zweite Bauelement (nicht dargestellt) durch die Öffnung in dem mindestens einen dritten Bauelement 136 hindurch gedrückt wird. Hierzu ist die Öffnung in dem mindestens einen dritten Bauelement 136 derart gebildet, dass das entsprechende mindestens eine zweite Bauelement 136 hindurch gedrückt werden kann. In einer Ausführung können an den Enden des teilweise freigelegten bzw. abgetrennten Bereichs von dem mindestens einen dritten Bauelement 136 Bohrungen gebildet sein, die für das teilweise Abtrennen bzw. Freilegen erforderlich sind, bzw. hinsichtlich der mechanischen Stabilität von Vorteil sind.

In **Fig. 4-2** ist eine schematische Draufsicht einer weiteren Ausführungsform 400B dargestellt. Die Ausführungsform 400B zeigt eine weitere Ausführungsform für das mindestens eine dritte Bauelement 136 in einer der Verbindungsstrukturen - bzw. anordnungen gemäß einer der zuvor beschriebenen Ausführungsformen. Die Ausführungsform 400B ist gemäß der zuvor beschriebenen Ausführungsform 400A gebildet, wobei in Ausführungsform 400B der schematische Querschnitt des mindestens einen zweiten Bauelements 134 einer Verbindungsstruktur bzw. -anordnung dargestellt ist, der durch die Öffnung innerhalb des mindestens einen dritten Bauelements 136 hindurch ragt, wobei die Öffnung mittels des teilweise Freilegens bzw. teilweise Abtrennens gebildet ist, gemäß einer der zuvor beschriebenen Ausführungsformen, und durch das Durchstecken des Bauelements 134 elastisch vergrößert wurde. Der in Ausführungsform 400B dargestellte Querschnitt des mindestens einen zweiten Bauelements 134 ist rund, wobei darüber hinaus das mindestens eine zweite Bauelement 134 auch alle zuvor genannten Formen aufweisen kann.

In **Fig. 4-3** ist eine schematische Draufsicht einer weiteren Ausführungsform 400C dargestellt. Die Ausführungsform 400C zeigt eine weitere Ausführungsform für das mindestens eine dritte Bauelement 136 in einer der Verbindungsstrukturen - bzw. anordnungen gemäß einer der zuvor beschriebenen Ausführungsformen. Die Ausführungsform 400C zeigt ein drittes Bauelement 136 einer Verbindungsstruktur bzw. -anordnung, gemäß einer der zuvor beschriebenen Ausführungsformen, welche innerhalb zumindest zwei teilweise freigelegte bzw. teilweise abgetrennte Bereiche aufweist, gemäß einer der oben genannten Ausführungsformen. Zwischen diesen Bereichen ist zumindest eine Öffnung gebildet, die es ermöglicht, mindestens ein zweites Bauelement (nicht dargestellt) gemäß mindestens einer der zuvor genannten Ausführungsformen durch diese Öffnung hindurch zu drücken. Wobei die beiden Bereiche auch ohne eine Öffnung, jedoch räumlich getrennt voneinander gebildet sein können.

In **Fig. 5-1** ist eine schematische Querschnittsansicht einer weiteren Ausführungsform 500A dargestellt. Die Ausführungsform 500A zeigt eine Verbindungsstruktur bzw. - anordnung, die zumindest teilweise gemäß der Ausführungsform 400C gebildet ist, wobei bei dieser Ausführungsform, die sich gegenüberliegenden Enden gemäß einer der zuvor beschriebenen Ausführungsformen gebogen sind und in dieser Ausführungsform die mindestens drei Bauelemente, 132, 134 und 136, dargestellt sind, gemäß mindestens einer zuvor beschriebenen Ausführungsform. Wie in zumindest einer der zuvor beschriebenen Ausführungsformen ist die erste Baugruppe 200 aus mindestens drei schichtförmig übereinander angeordneten Modulen und/oder Werkstoffen bzw. Schichten, 210, 220 und 230, gebildet. Diese mindestens drei Module und/oder Schichten können gemäß einer der zuvor genannten Ausführungsformen gebildet sein bzw. deren chemische und/oder physikalische Eigenschaften aufweisen. In Ausführungsform 500A ist die mindestens eine erste Baugruppe 240 als eine Platte, bspw. die rückseitige Platte einer elektrischen Maschine, bzw. eines Moduls, dargestellt, wobei diese Baugruppe auch aus mehr als einem Modul bzw. einer Platte gebildet sein kann. Darüber hinaus kann optional ein Bauteil 520, bspw. in Form einer Unterlegscheibe, unterhalb zumindest eines Teils des mindestens einen dritten Bauelements 136 angeordnet sein, zwischen der mindestens einen zweiten Baugruppe 200 und dem mindestens einen dritten Bauelement 136. Um den Höhenunterschied auf den beiden Seiten der Verbindungsstruktur bzw. -anordnung auszugleichen und so eine gleichverteilte Vorspannung zu ermöglichen, wird ein Modul bzw. Bauteil 530 mit einer Höhe, die zumindest teilweise der Höhe der mindestens einen zweiten Baugruppe 200 entspricht, auf der Seite der Verbindungsstruktur bzw. - anordnung angeordnet, auf der die mindestens eine zweite Baugruppe 200 nicht angeordnet ist und entweder zwischen dem mindestens einen dritten Bauelement 136 oder dem optionalen Modul bzw. Bauteil 520 und der mindestens einen ersten Baugruppe 240. Das Modul bzw. das Bauteil 530 ist in einer Ausführungsform elektrisch nicht leitfähig und mechanisch insbesondere auf Druck belastbar und unter Druckbelastung formstabil. Bauteil 520 ist in einer Ausführungsform elektrisch leitfähig und mechanisch insbesondere auf Druck belastbar und unter Druckbelastung formstabil.

In **Fig. 5-2** ist eine schematische Querschnittsansicht einer weiteren Ausführungsform 500B dargestellt. Die Ausführungsform 500B zeigt eine Verbindungsstruktur bzw. -anordnung, die im Wesentlichen gemäß der Ausführungsform 500A gebildet ist bzw. einer der zuvor beschriebenen Ausführungsformen. Hiervon unterscheiden sich lediglich das mindestens eine dritte Bauelement 136 und das mindestens eine weitere Bauteil 510, welches über dem Bauelement 136 angeordnet ist. Das Bauteil 510 ist kraftschlüssig mit dem zweiten Bauteil 134 verbunden, bspw. durch einer bzw. mittels einer beidseitige(n) Oberflächenperforation 250, wie bspw. ein Gewinde oder einer Strukturierung. Das Bauteil 510 kann eine Mutter sein. Das mindestens eine dritte Bauelement 136 ist gemäß der Ausführungsform 500B derart gebildet, dass das Bauelement 136 wie ein Federteil, bspw. ein Teil einer mechanischen Feder, gebildet ist und das mindestens eine zweite Bauelement 134 zumindest teilweise umgibt. Das dritte Bauelement 136 wird zwischen den beiden Modulen bzw. Bauelementen, 510 und 520, angeordnet und zusammengedrückt. Aufgrund der Federwirkung des Bauelements 136 wird diese Vorspannung auf die mindestens zwei Baugruppen, 200 und 240, ausgeübt.

In **Fig. 6** ist eine schematische Querschnittsansicht einer weiteren Ausführungsform 600 dargestellt. Hierin können die Komponenten, Bauteile bzw. -elemente bzw. Module gemäß mindestens einer zuvor beschriebenen Ausführungsform oder deren Komponenten gebildet sein bzw. diese aufweisen. Die Ausführungsform 600 kann wie in Fig. 5 dargestellt bspw. als eine elektrische Antriebseinheit gebildet sein, aufweisend zumindest eine elektrische Maschine, die zumindest teilweise in einem Gehäuse bzw. Modulgehäuse 648 angeordnet ist, wobei das Modulgehäuse alle Komponenten bis auf Durchbrüche für bspw. Steckverbinder aufweist, zumindest ein Kühlsystem 644 (bzw. zumindest ein Teil einer Baugruppe gemäß mindestens einer der Baugruppen 110), wobei das Kühlsystem 644 einen Kühlkanal 652 oder mehrere Kühlkanäle 652 aufweisen kann, zumindest ein oder mehrere leistungselektronische Module 610 (bzw. 120), die jeweils als Inverter an die elektrische Maschine 640 elektrisch leitfähig gekoppelt bzw. angeschlossen sind, dadurch gekennzeichnet dass ein Kühlsystem bzw. Kühlkörper bzw. eine Wärmesenke 644 (bzw. zumindest ein Teil von einer Baugruppe gemäß zumindest einer der zuvor beschriebenen Baugruppe 110) zwischen elektrischer Maschine 640 und zumindest einem leistungselektronischem Inverter 610 (bzw. gemäß zumindest einem Teil mindestens einer der Baugruppen 110) angeordnet ist und von zumindest einem zweiten Element, 666 bzw. 134, einer aus einem ersten, einem zweiten und einem dritten Element, 662 bzw. 664 bzw. 132, 666 bzw. 134 und 670 bzw. 672 bzw. 674 bzw. 136, bestehenden multifunktionalen Verbindungsvorrichtung 650 durchdrungen wird, wobei das erste und das zweite, 662 bzw. 132 und 666 bzw. 134, sowie das zweite und das dritte Element, 666 bzw. 134 und 670 bzw. 136, mechanisch kraftschlüssig miteinander verbunden sind; wobei das zweite Element, 666 bzw. 134, der multifunktionalen Verbindungsvorrichtung 650 mit dem Kühlsystem bzw. Kühlkörper bzw. Wärmesenke, 644 bzw. 110, elektrisch isoliert und mechanisch kraftschlüssig mit Hilfe eines ersten Elementes, 662 bzw. 132, der multifunktionalen Verbindungsvorrichtung 650 verbunden ist, welches das zweite Element, 666 bzw. 134, von dem Kühlsystem, 644 bzw. 110, elektrisch isoliert und das zweite Element, 666 bzw. 134, mit dem Kühlsystem 644 bzw. 110 kraftschlüssig verbindet; wobei der dritte Teil, 670 bzw. 136, der multifunktionalen Verbindungsvorrichtung 650 eine Federwirkung auf die Grenzfläche zwischen der elektrischen Maschine 640 und/oder den Kühlkörper, 644 bzw. 110, und/oder das zumindest eine leistungselektronische Modul, 610 bzw. 120, ausübt und somit die elektrischen Maschine 646 und/oder den Kühlkörper, 644 bzw. 110, und/oder das zumindest eine leistungselektronische Modul, 610 bzw. 120 aufeinander presst und dadurch einen thermischen Kontakt zwischen der elektrischen Maschine 640 und/oder dem Kühlkörper, 644 bzw. 110, und/oder dem zumindest einen leistungselektronischen Modul, 610 bzw. 120, herstellt; und wobei das zweite und das dritte Element, 666 bzw. 134 und 670 bzw. 136, der multifunktionalen Verbindungsvorrichtung 650 elektrisch leitend miteinander verbunden sind und das zweite und das dritte Element, 666 bzw. 134 und 670 bzw. 136, der multifunktionalen Verbindungsvorrichtung 650 einen elektrischen Kontakt zwischen zumindest einem elektrischen Anschluss der elektrischen Maschine 640 und zumindest einem elektrischen Anschluss des zumindest einen leistungselektronischen Moduls, 610 bzw. 120, herstellen. Dabei kann das mindestens eine leistungselektronische Modul, 610 bzw. 120, mindestens ein Substrat 612 mit mindestens einem Keramikträger 614, mindestens einer oberseitigen Oberflächenmetallisierung 616 und mindestens einer unterseitigen Oberflächenmetallisierung 618 aufweisen, wobei zumindest über einem Bereich der oberseitigen Oberflächenmetallisierung 616 mindestens ein Leistungshalbleiterchip 620 angeordnet ist, der über mindestens eine Drahtbondverbindung 622 elektrisch leitfähig mit einem Teil der oberseitigen Oberflächenmetallisierung 616 gekoppelt ist. Das leistungselektronische Modul, 610 bzw. 110, kann bspw. zumindest teilweise von einer Vergussmasse 624 und/oder zumindest teilweise von mindestens einem Modulgehäuse 626 umgeben sein. Hierbei kann der Modulverguss bzw. die Vergussmasse 624 auch im Bereich des Verbindungselementes 650 gebildet sein, bzw. kann auch flexibel gebildet sein bzw. flexibel sein und kann dabei beim Einführen des Verbindungselementes 650 von diesem weggeschoben werden. Darüber hinaus kann ein Kontaktstift 630 oder mehrere Kontaktstifte 630, auf der oberseitigen Oberflächenmetallisierung 616 des Modulsubstrates 612 aufgebracht sein, um das leistungselektronische Modul, 610 bzw. 110, mit einem übergeordneten Schaltungsträger oder/und einem übergeordneten leistungselektronischen System elektrisch leitfähig zu verbinden. Hierin beschreibt der Begriff "leistungselektronisches Modul" alle elektrisch bzw. elektronisch aktiven Elemente, Bauteile oder Module in jeder vorhergehenden oder noch folgenden Ausführungsform, die nicht zur Verbindungsstruktur bzw. -anordnung gezählt werden oder dazu gehören. Die elektrische Maschine 640 kann mindestens ein Gehäuse 642 aufweisen bzw. mindestens eine äußere Wandung 648, wobei durch den Kühlkörper, 644 bzw. 110, mit einem bspw. fluidischen Kühlkreislauf bzw. -kanäle 652, und der Wandung 648 bzw. dem Gehäuse 642 mindestens ein Innenraum der E-Maschine 646 gebildet wird, der verschiedenste Komponenten bzw. Bauteile der elektrischen Maschine 640 aufnehmen kann. In der Ausführungsform 600 sind ohne Beschränkung der Allgemeinheit zwei multifunktionale Verbindungsvorrichtungen 650 dargestellt, wobei jedoch Ausführungsformen auch weniger oder mehr als zwei multifunktionale Verbindungsvorrichtungen 650 aufweisen können.

In **Fig. 7** ist eine schematische Querschnittsansicht einer weiteren Ausführungsform 700 dargestellt. Die Ausführungsform 700 kann zumindest einen Teil, einer Komponente bzw. ein Element oder mehrere Teile, Komponenten bzw. Elemente mindestens einer der zuvor beschriebenen Ausführungsform aufweisen oder zumindest teilweise aus mindestens einem Element, einer Komponente bzw. Teilen mindestens einer der zuvor beschriebenen Ausführungsform gebildet sein. Dabei beschreiben gleiche Bezugszeichen gleiche Teile, Element bzw. Komponenten mindestens einer der zuvor beschriebenen Ausführungsformen. In Fig. 7 ist aus Gründen der Vereinfachung lediglich der obere Teil einer ähnlichen Ausführungsform einer elektrischen Antriebseinheit bzw. einer Elektrischen Maschine (d.h. einer E-Maschine) dargestellt gemäß Ausführungsform 600. In der dargestellten Ausführungsform 700 ist die mindestens eine Verbindungsstruktur bzw. -anordnung 650, aufweisend ein erstes Bauelement, 662 bzw. 132, ein zweites Bauelement, 666 bzw. 134, und ein drittes Bauelement, 670 bzw. 136, durch mindestens eine Öffnung hindurch angeordnet, wobei sich die Öffnung zumindest teilweise durch den Kühlkörper, -system bzw. die Wärmesenke und/oder durch das Substrat 614 und dessen beiden Oberflächenmetallisierungen, 616 und 618, hindurch erstreckt. Die Öffnung ist derart gebildet, dass das die Verbindungsstruktur bzw. -anordnung 650 darin aufgenommen werden kann, wobei die Öffnung zentral bzw. auch dezentral in der Ausführungsform 700 angeordnet sein kann. Die Verbindungsstruktur bzw. -anordnung 650, ist dabei ähnlich der Ausführungsform 500B, dargestellt in Fig. 5-2, gebildet. D.h. dass gemäß diesen beiden Ausführungsformen, 500B bzw. 700, das zweite Bauelement, 666 bzw. 134, durch zumindest eine Gewindemutter 710 des dritten Elementes 670, mindestens eine Federscheibe, 670 bzw. 136, und mindestens einen Anpressdruckverteiler 720 bzw. Druckauflage 720, bspw. eine Unterlegscheibe, eine Vorspannung aufgrund der Federscheibe auf die mindestens zwei darunter angeordneten Module bzw. Baugruppen, 610 bzw. 120 und 644 bzw. 110, appliziert. Dabei weist das zweite Element bzw. Bauelement, 666 bzw. 134, zumindest teilweise mindestens ein Gewinde bzw. eine Oberflächenstrukturierung bzw. -rauhigkeit 668 auf, die es ermöglicht Gewindemutter 710 mit dem zweiten Element bzw. Bauelement, 666 bzw. 134, zu verbinden. D.h. es ist zumindest teilweise mindestens ein Gewinde bzw. eine Oberflächenstrukturierung bzw. -rauhigkeit 668 an den äußeren Kontaktflächen des zweiten Elements bzw. Bauelements, 666 bzw. 134, gebildet, mittels dem eine Verbindung zwischen der Gewindemutter 710 und dem zweiten Element bzw. Bauelement, 666 bzw. 134, zu bilden. Die in der Ausführungsform 700 dargestellten Baugruppen sind gemäß der Ausführungsform 600 gebildet bzw. weisen gleiche Eigenschaften auf.

In **Fig. 8** ist eine schematische Querschnittsansicht einer weiteren Ausführungsform 800 dargestellt. Die Ausführungsform 800 kann zumindest einen Teil, einer Komponente bzw. ein Element oder mehrere Teile, Komponenten bzw. Elemente mindestens einer der zuvor beschriebenen Ausführungsformen aufweisen oder zumindest teilweise aus mindestens einem Element, einer Komponente bzw. Teilen mindestens einer der zuvor beschriebenen Ausführungsformen gebildet sein. Dabei beschreiben gleiche Bezugszeichen gleiche Teile, Element bzw. Komponenten mindestens einer der zuvor beschriebenen Ausführungsformen. In der Ausführungsform 800 ist die multifunktionale Verbindungsvorrichtung 650 mit einem zweiten und dritten Element zumindest teilweise gemäß der Ausführungsform 100 gebildet bzw. weist ein solches auf. Zusätzlich zu dem einen zumindest teilweise freigelegten bzw. teilweise abgetrennten Bereich gemäß Ausführungsform 100 weist die Ausführungsform 800 zumindest einen zusätzlichen zumindest teilweise freigelegten bzw. teilweise abgetrennten Bereich auf, wobei diese mindestens zwei Bereiche gemäß der Ausführungsform 100 gebildet sind. Wie in Ausführungsform 100 wird auch in Ausführungsform 800 in dem zweiten Element, 666 bzw. 134, ein drittes Element, 670 bzw. 672 bzw. 674 bzw. 136, durch zumindest teilweises Freilegen bzw. teilweises Abtrennen eines Bereichs innerhalb des zweiten Elements, 666 bzw. 134, gebildet, d.h. auch gemäß zumindest einer der zuvor genannten Verfahren zur Metallbearbeitung, mit denen ein Bereich teilweise freigelegt bzw. freigelegt werden kann. Ferner sind die mindestens zwei Bereiche derart gebogen, dass ihre Vorspannung diese mindestens zwei Bereiche entgegengesetzt zueinander in mindestens zwei Richtungen biegt bzw. spannt. Mit anderen Worten, die Federwirkung der mindestens zwei Bereiche führt dazu, dass sich diese Bereiche beim Entspannen entgegengesetzt zueinander entfalten.

In **Fig. 9** ist eine schematische Querschnittsansicht einer weiteren Ausführungsform 900 dargestellt. Die Ausführungsform 900 kann zumindest einen Teil, einer Komponente bzw. ein Element oder mehrere Teile, Komponenten bzw. Elemente mindestens einer der zuvor beschriebenen Ausführungsform aufweisen oder zumindest teilweise aus mindestens einem Element, einer Komponente bzw. Teilen mindestens einer der zuvor beschriebenen Ausführungsformen gebildet sein. Dabei beschreiben gleiche Bezugszeichen gleiche Teile, Element bzw. Komponenten mindestens einer der zuvor beschriebenen Ausführungsformen. In Fig. 9 ist, wie in Fig. 7, aus Gründen der Vereinfachung lediglich der obere Teil einer ähnlichen Ausführungsform einer elektrischen Antriebseinheit bzw. einer elektrischen Maschine (d.h. einer E-Maschine) dargestellt gemäß zumindest der Ausführungsform 600. In der dargestellten Ausführungsform 900 ist die mindestens eine Verbindungsstruktur bzw. - anordnung 650, aufweisend ein erstes Bauelement, 662 bzw. 132, ein zweites Bauelement, 666 bzw. 134, und ein drittes Bauelement, 670 bzw. 136, durch mindestens eine Öffnung hindurch angeordnet, wobei sich die Öffnung zumindest teilweise durch den Kühlkörper, das Kühlsystem bzw. die Wärmesenke und/oder durch das Substrat 614 und dessen beide Oberflächenmetallisierungen, 616 und 618, hindurch erstreckt. Die Öffnung ist derart gebildet, dass die Verbindungsstruktur bzw. -anordnung 650 darin aufgenommen werden kann, wobei die Öffnung zentral bzw. auch dezentral in der Ausführungsform 900 angeordnet sein kann. Die Verbindungsstruktur bzw. -anordnung 650, ist dabei ähnlich der Ausführungsform 500B bzw. 700, dargestellt in Fig. 5-2 bzw. Fig. 7, gebildet. D.h. das gemäß diesen Ausführungsformen, 500B bzw. 700 und 900, das zweite Bauelement, 666 bzw. 134, durch zumindest eine Gewindemutter 710 des dritten Elementes 670, mindestens eine federnde Druckverteilung, 670 bzw. 136, und mindestens einen oder mehrere Anpressdruckverteiler 720 bzw. Druckauflage(n) 720, bspw. eine Unterlegscheibe oder ähnliches, eine Vorspannung aufgrund der federnden Druckverteilung, 670 bzw. 136, auf die mindestens zwei darunter angeordneten Module bzw. Baugruppen, 610 bzw. 120 und 644 bzw. 110, appliziert. Die federnde Druckverteilung, 670 bzw. 136, ist derart gebildet, dass die federnde Druckverteilung, 670 bzw. 136, sich über mindestens einen Bereich über der Baugruppe, 610 bzw. 120, erstreckt, so dass die die federnden Druckverteilung, 670 bzw. 136, eine Vorspannung bzw. Druck auf mindestens einen Bereich der Baugruppe, 610 bzw. 120, ausübt. Dabei weist das zweite Element bzw. Bauelement, 666 bzw. 134, zumindest teilweise mindestens ein Gewinde bzw. eine Oberflächenstrukturierung bzw. -rauhigkeit 668, die an den äußeren Kontaktflächen des zweiten Bauelements gebildet ist, auf, welche es ermöglicht eine Gewindemutter 710 mit dem zweiten Element bzw. Bauelement, 666 bzw. 134, zu verbinden. Die in der Ausführungsform 900 dargestellten Baugruppen sind gemäß der Ausführungsform 600 gebildet bzw. weisen gleiche Eigenschaften auf.

### Bezugszeichenliste

- **110**: Erste elektrisch und thermisch aktive Baugruppe
- **112**: Obere Oberfläche der ersten Baugruppe 110
- **114**: Untere Oberfläche der ersten Baugruppe 110
- **120**: Zweite elektrisch und thermisch aktive Baugruppe
- **122**: Obere Oberfläche der zweiten Baugruppe 120
- **124**: Untere Oberfläche der zweiten Baugruppe 120
- **130**: Verbindungsstruktur bzw. -anordnung
- **132**: Erstes Element bzw. hierin synonym verwendet auch als Bauelement bezeichnet
- **134**: Zweites Element bzw. Bauelement
- **136**: Drittes Element bzw. Bauelement
- **200**: Substrat einer thermisch und elektrisch aktiven Baugruppe
- **210**: Oberseitige Metallisierungsschicht des Substrats 200
- **220**: Elektrisch isolierende Trägerplatte des Substrats 200
- **230**: Unterseitige Metallisierungsschicht des Substrats 200
- **240**: Thermisch und elektrisch aktive Baugruppe
- **250**: Zumindest teilweise gebildetes Gewinde oder Oberflächenrauhheit, bzw. Oberflächenstrukturierung des dritten Bauelements 136, welche an den äußeren Kontaktflächen des dritten Elements gebildet ist
- **310**: Elektrisch und thermisch aktive Baugruppe
- **510**: Bauteil bspw. u.a. eine Mutter etc.!
- **520**: Bauteil bspw. u.a. eine Unterlegscheibe etc.
- **530**: Bauteil bspw. u.a. Abstandshalter etc.
- **610**: Leistungselektronisches Modul aufweisend bspw. Substrat, Steckverbinder, Gehäuse, usw.
- **614**: Substrat bzw. Keramikträger bzw. entspricht einer Trägerplatte 220
- **616**: Oberseitige Oberflächenmetallisierung bzw. entspricht einer Metallisierungsschicht 210
- **618**: Unterseitige Oberflächenmetallisierung bzw. entspricht einer Metallisierungsschicht 230
- **620**: Leistungshalbleiterchip
- **622**: Drahtbondverbindung
- **624**: Vergussmasse
- **626**: Modulgehäuse
- **630**: Kontaktstift aufgebracht auf Metallisierung 616 bzw. 220 des Modulsubstrates 612 bzw. 200
- **640**: Elektrische Maschine
- **642**: Gehäuse der elektrischen Maschine
- **644**: (Fluidischer) Kühlkreislauf bzw. Kühlelement bzw. Wärmesenke
- **646**: Innenraum der E-Maschine
- **648**: Außenwandung, bzw. Gehäuse der E-Maschine
- **650**: Multifunktionale Verbindungsvorrichtung, bzw. -struktur gemäß 130
- **652**: Kühlkanäle bzw. ein Teil des Kühlkreislaufs 644
- **662**: Erstes Element der multifunktionalen Verbindungsvorrichtung 650, aufweisend mindestens einen elektrischer Isolierkörper der multifunktionalen Verbindungsvorrichtung 650, wobei das erste Element 662 dem ersten Element 132 entspricht
- **666**: Zweites Element der multifunktionalen Verbindungsvorrichtung 650 bzw. ein Kontaktstift eingebettet in Isolierkörper des ersten Elements 662, wobei das zweite Element 666 dem zweiten Element 134 entspricht
- **668**: Zumindest teilweise gebildetes Gewinde oder Oberflächenrauhheit, bzw. Oberflächenstrukturierung des Kontaktstiftes 666
- **670**: Drittes Element der multifunktionalen Verbindungsvorrichtung 650, bzw. federndes Befestigungselement bzw. Federteil bzw. Federscheibe des dritten Elementes 670 der multifunktionalen Verbindungsvorrichtung 650, wobei das dritte Element 670 dem dritten Element 136 entspricht
- **710**: Gewindemutter des dritten Elementes 670
- **720**: Anpressdruckverteiler des dritten Elementes 670 bzw. Druckauflage des dritten Elementes 670

## Patentansprüche

1. Vorrichtung (100), aufweisend
1.1. mindestens eine erste und eine zweite thermisch und elektrisch aktive Baugruppe (110,120);
1.2. wobei beide Baugruppen (110, 120) jeweils eine obere Oberfläche (112, 122) und eine untere Oberfläche (114, 124) aufweisen und wobei sich die obere Oberfläche (112) und die untere Oberfläche (114) der Baugruppe (110), sowie die obere Oberfläche (122) und die untere Oberfläche (124) der Baugruppe (120) gegenüberliegen;
1.3. wobei die zweite Baugruppe (120) derart über der ersten Baugruppe (110) angeordnet ist, dass zumindest teilweise die obere Oberfläche (112) der ersten Baugruppe (110) flächig an die untere Oberfläche (124) der zweiten Baugruppe (120) angrenzt;
1.4. und wobei thermische Energie (T) durch die beiden aneinander angrenzenden Oberflächen (112, 124) austauschbar ist; und
1.5. mindestens eine multifunktionale Verbindungsvorrichtung (130), aufweisend:
1.6. mindestens drei Bauelemente (132, 134, 136)
**dadurch gekennzeichnet, dass**
1.6.1. das erste Bauelement (132) mindestens einen elektrisch isolierenden Körper aufweist;
1.6.2. das zweite Bauelement (134) mindestens einen elektrisch leitfähigen Körper aufweist, wobei das erste Bauelement (132) eine elektrische Isolierung zwischen dem zweiten Bauelement (134) und mindestens einer Baugruppe (110, 120) bildet;
1.6.3. das dritte Bauelement (136) mindestens einen elektrisch leitfähigen und mechanisch federnden Körper aufweist;
1.6.4. sich das zweite Bauelement (134) durch das erste Bauelement (132) hindurch erstreckt und fest oder drehbar mit dem ersten Bauelement (132) verbunden ist;
1.6.5. sich das zweite Bauelement (134) zumindest teilweise über das erste Bauelement (132) hinaus erstreckt;
1.6.6. das erste Bauelement (132) fest in mindestens eine der beiden Baugruppen (110, 120) eingesetzt ist;
1.6.7. sich das erste und das zweite Bauelement (132, 134) zumindest teilweise durch zumindest eine der beiden Baugruppen (110, 120) hindurch erstrecken;
1.6.8. das dritte Bauelement (136) eine elastische Verbindung zwischen einer der beiden Baugruppen (110, 120) und dem zweiten Bauelement (134) bildet; und
1.6.9. zumindest die elastische Verbindung eine Vorspannung der beiden Baugruppen (110, 120) gegeneinander bildet.

2. Vorrichtung (100) gemäß Anspruch 1, wobei die Bauelemente (132, 134, 136) zumindest teilweise jeweils aus mehr als einem Bauteil gebildet sind und wobei die Bauteile zumindest aus einem Bauteil aus der Gruppe von Bauteilen gebildet sind, wobei die Gruppe aufweist: Metallstift, Gewindestift, Mutter, Unterlegscheibe Federscheibe, Sprengring, Federring.

3. Vorrichtung (100) gemäß zumindest einem der zuvor genannten Ansprüche 1 oder 2, wobei die Bauelemente (132, 134, 136) jeweils aus mehr als einem Bauteil gebildet sind und wobei die dem jeweiligen Element zugordneten Bauteile miteinander kraftschlüssig verbunden sind.

4. Vorrichtung (100) gemäß zumindest einem der zuvor genannten Ansprüche 1 bis 3, wobei die erste Baugruppe (110) eine Kühleinheit aufweist, welche thermische Energie (T) abführt, die zumindest teilweise über die obere Oberfläche (112) der ersten Baugruppe (110) eingeführt wird und die zweite Baugruppe (120) zumindest einen Teil der insgesamt von der Kühleinheit abgeführten Energie (T) an der unteren Oberfläche (124) der zweiten Baugruppe (120) bereitstellt.

5. Vorrichtung (100) gemäß zumindest einem der zuvor genannten Ansprüche 1 bis 4,
5.1. wobei die zweite Baugruppe (120) zumindest einen Teil der von oder ersten Baugruppe (110) aufgenommenen elektrischen Energie (E) über mindestens ein multifunktionales Verbindungselement (130) der ersten Baugruppe (110) bereitstellt; und
5.2. wobei die zweite Baugruppe (120) zumindest teilweise mittels elektrischer Leitungen, welche die obere Oberfläche (122) der zweiten Baugruppe (120) durchdringen, mit elektrischer Energie und/oder elektrischen Signalen versorgt wird.

6. Vorrichtung (100) gemäß zumindest einem der zuvor genannten Ansprüche 1 bis 5, wobei die erste Baugruppe (110) und/oder die zweite Baugruppe (120) mindestens eine Baugruppe aus der Gruppe von Baugruppen ist/sind, wobei diese Gruppe umfasst: Peltierelemente, optische Strahlungsquellen, thermische Strahlungsquellen, elektromagnetische Strahlungsquellen, Teilchenstrahlungsquellen, elektrische Maschinen, leistungselektronische Vorrichtungen, elektrische Vorrichtungen.

7. Vorrichtung (100) gemäß zumindest einem der zuvor genannten Ansprüche 1 bis 6, wobei die Bauelemente (132, 134, 136) jeweils zumindest teilweise mindestens ein Material aus einer Gruppe von Materialien aufweisen, wobei diese Gruppe umfasst: Kunststoffe, Metalle, Keramik, Halbleiter, Holz.

8. Elektrische Antriebseinheit, aufweisend
8.1. zumindest eine elektrische Maschine (640), die zumindest teilweise in einem Gehäuse (642) angeordnet ist,
8.2. zumindest ein Kühlsystem (644),
8.3. zumindest ein oder mehrere leistungselektronische Module (610), die jeweils als Inverter elektrisch an die elektrische Maschine (640) angeschlossen sind,
8.4. **dadurch gekennzeichnet dass:**
8.4.1. das Kühlsystem (644) zwischen elektrischer Maschine (640) und zumindest einem leistungselektronischen Modul (610) angeordnet ist und von zumindest einem zweiten Element (666) einer aus einem ersten (662), einem zweiten (666) und einem dritten Element (670) gebildeten multifunktionalen Verbindungsvorrichtung (650) durchdrungen wird, wobei das erste (662) und das zweite (666) sowie das zweite (666) und das dritte Element (670) mechanisch kraftschlüssig miteinander verbunden sind;
8.4.2. wobei das zweite Element (666) der multifunktionalen Verbindungsvorrichtung (650) mit dem Kühlsystem (644) elektrisch isoliert und mechanisch kraftschlüssig mit Hilfe eines ersten Elementes (662) der multifunktionalen Verbindungsvorrichtung (650) verbunden ist, welches das zweite Element (666) von dem Kühlsystem (644) elektrisch isoliert und das zweite Element (666) mit dem Kühlsystem (644) kraftschlüssig verbindet;
8.4.3. wobei das dritte Element (670) der multifunktionalen Verbindungsvorrichtung (650) eine Federwirkung auf die Grenzfläche zwischen der elektrischen Maschine (640) und/oder den Kühlkörper (644) und/oder das zumindest eine leistungselektronische Modul (610) ausübt und somit die elektrische Maschine (640) und/oder den Kühlkörper (610) und/oder das zumindest eine leistungselektronische Modul (610) aufeinander presst und dadurch einen thermischen Kontakt zwischen der elektrischen Maschine (640) und/oder dem Kühlkörper (644) und/oder dem zumindest einen leistungselektronischen Modul (610) bildet; und
8.4.4. wobei das zweite (666) und das dritte Element (670) der multifunktionalen Verbindungsvorrichtung (650) elektrisch leitend miteinander verbunden sind und das zweite (666) und das dritte Element (670) der multifunktionalen Verbindungsvorrichtung (650) einen elektrischen Kontakt zwischen zumindest einem elektrischen Anschluss der elektrischen Maschine (640) und zumindest einem elektrischen Anschluss des zumindest einen leistungselektronischen Moduls (610) bildet.

9. Elektrische Antriebseinheit gemäß Anspruch 8,
**dadurch gekennzeichnet, dass**
9.1. die multifunktionale Verbindungsvorrichtung (650) mindestens einen Kontaktstift als zweitem Element (666), mindesten eine Isolationshülse als erstem Element (662) sowie mindestens ein federndes Befestigungselement als drittem Element (670) aufweist;
9.2. wobei der Kontaktstift (666) aus einem formstabilen, elektrisch leitfähigen Material, vorzugsweise aus einer Kupferlegierung, gebildet ist;
9.3. wobei die Isolationshülse (662) aus einem formstabilen, elektrisch isolierenden Material, vorzugsweise aus einem faserverstärkten Kunststoff oder einem Keramikwerkstoff, gebildet ist;
9.4. wobei das federnde Befestigungselement (670) zumindest teilweise aus einem elektrisch leitfähigen Federmaterial, vorzugsweise Federstahl oder/und Federbronze, gebildet ist; und
9.5. wobei das federnde Befestigungselement (670) zumindest teilweise formschlüssig mit dem Kontaktstift (666) verbunden ist und formschlüssig auf einer Oberseitenmetallisierung (616) eines Keramiksubstrates (614) des leistungselektronischen Moduls (610) aufliegt.

10. Elektrische Antriebseinheit gemäß einem der zuvor genannten Ansprüche 8 oder 9,
**dadurch gekennzeichnet, dass**
10.1. die multifunktionale Verbindungsvorrichtung (650) einen Kontaktstift (666) und eine Isolationshülse (662) aufweist;
10.2. wobei der Kontaktstift (666) aus einem zumindest teilweise elastischen, elektrisch leitfähigen Material, vorzugsweise aus Federstahl, gebildet ist;
10.3. wobei die Isolationshülse (662) aus einem formstabilen, elektrisch isolierenden Material, vorzugsweise aus einem faserverstärkten Kunststoff oder/und einer Keramik, gebildet ist; und
10.4. wobei der Kontaktstift (666) zumindest teilweise formschlüssig auf der Oberseitenmetallisierung (616) des Keramiksubstrates (614) des leistungselektronischen Moduls (610) aufliegt.

11. Elektrische Antriebseinheit gemäß zumindest einem der zuvor genannten Ansprüche 8 bis 10,
**dadurch gekennzeichnet, dass**
die Isolationshülse (662) und/oder der Kontaktstift (666) entlang ihrer jeweils längsten Ausdehnung unterschiedliche Durchmesser aufweisen und miteinander und mit dem Kühlkörper (644) formschlüssig verbunden sind.

12. Elektrische Antriebseinheit gemäß zumindest einem der Ansprüche 8 bis 11,
**dadurch gekennzeichnet, dass**
12.1. das Befestigungselement (670) und/oder die Isolationshülse (662) und/oder der Kontaktstift (666) jeweils aus mehr als einem Teilelement gebildet ist;
12.2. wobei der Kontaktstift (666) eine Oberflächenperforation (668), in welche ein erstes Teilelement des Befestigungselementes, welches ein Loch mit einer Oberflächenperforation aufweist, eingreift, und ein zweiter Teil des Befestigungselementes den Radius des Kontaktstiftes zumindest teilweise umspannt und eine mechanische Federwirkung zwischen dem ersten Teilelement des Befestigungselementes und der Oberseitenmetallisierung (616) des Keramiksubstrates (614) ausübt.

13. Eine elektrische Antriebseinheit gemäß zumindest einem der zuvor genannten Ansprüche 8 bis 12,
**dadurch gekennzeichnet, dass**
das keramische Substrat (614) des leistungselektronischen Moduls (610) ein- oder beidseitig mittels DCB-Technik oder/und Dickfilmtechnik mit leitfähigen und/oder lötfähigen und/oder sinterfähigen und/oder klebefähigen elektrisch leitfähigen metallischen Strukturen versehen ist, wobei die metallischen Strukturen zumindest teilweise ein Metall aus der Gruppe von Metallen aufweisen, wobei die Gruppe von Metallen umfasst: Kupfer, Silber, Palladium.

14. Elektrischen Antriebseinheit gemäß zumindest einem der zuvor genannten Ansprüche 8 bis 13,
**dadurch gekennzeichnet, dass**
14.1. der Kühlkörper (644) ein fluidisches Kühlmedium aufweist;
14.2. wobei das fluidische Kühlmedium zumindest teilweise Wasser und/oder Öl aufweist; und
14.3. wobei das Kühlmedium derart vom Kühlkörper (644) umschlossen ist, dass das auf den Kühlkörper (644) gepresste leistungselektronische Modul (610) nicht in direkten Kontakt zum Kühlmedium steht; oder dass das Kühlmedium die Unterseite des Moduls (610) direkt umspült, wozu im Kühlkreislauf des Kühlkörpers (644) an der Auflagestelle des leistungselektronischen Moduls (610) zumindest eine Öffnung vorgesehen ist.

15. Elektrische Antriebseinheit gemäß zumindest einem der zuvor genannten Ansprüche 8 bis 14,
**dadurch gekennzeichnet, dass**
die elektrische Maschine (640) mindestens eine elektrische Maschine aus der Gruppe von elektrischen Maschinen ist, wobei die Gruppe umfasst: Lichtmaschine, Startergenerator, Gleichstrommaschine, Synchronmaschine, Asynchronmaschine, permanenterregte Maschine, elektronisch kommutierte Maschine, Schrittmotor.
